# EUROPEAN PATENT APPLICATION

(11) **EP 3 415 808 A1**
(43) Date of publication of application: **19.12.2018**
(21) Application number: 17750136.8
(22) Date of filing: 01.02.2017
(51) Int. Cl.: F21S 2/00, B60Q 1/04, B60Q 11/00, F21S 8/10, F21V 9/16, F21V 23/00, F21V 29/502, H01S 5/02, H01S 5/0683, F21W 101/10, F21Y 115/30

(54) **LIGHT SOURCE DEVICE AND PROJECTION DEVICE**

(30) Priority: 09.02.2016 JP 2016023127
(71) Applicant: Panasonic Intellectual Property Management Co., Ltd., Osaka-shi, Osaka 540-6207 (JP)
(72) Inventor: UENO, Hirotaka, Osaka-shi, Osaka 540-6207 (JP); YAMAGUCHI, Hideo, Osaka-shi, Osaka 540-6207 (JP); FUKAKUSA, Masaharu, Osaka-shi, Osaka 540-6207 (JP); YAMANAKA, Kazuhiko, Osaka-sho, Osaka 540-6207 (JP)
(74) Representative: Appelt, Christian W.
(86) International application number: PCT/JP2017/003527
(87) International publication number: WO 2017/138412

(57) **Abstract**

A light source device (101) includes: a semiconductor light emitting device (1) which emits laser light; a wavelength conversion component (4) which emits fluorescence by being irradiated with the laser light emitted from the semiconductor light emitting device (1) as excitation light; and a photodetector (7) on which a portion of light emitted from the wavelength conversion component (4) is incident. The photodetector (7) is disposed at a location off a light path of usable radiation light which is emitted from the wavelength conversion component (4) to a space and used as illumination light.

## Description

### TECHNICAL FIELD

The present disclosure relates to light source devices and projection devices, and particularly relates to: a light source device which uses light emitted from a wavelength conversion component as a result of irradiating the wavelength conversion component with light emitted from a semiconductor light emitting device and is used in the field of displays including a projection display device or in the field of lighting including vehicular lighting, commercial lighting, and medical lighting; and a projection device including the light source device.

### BACKGROUND ART

In order to emit light with a high luminous flux, a light source device and a projection device using a semiconductor light emitting device including a semiconductor light emitting element such as a semiconductor laser is required to efficiently use light emitted from a wavelength conversion component as a result of irradiating the wavelength conversion component with light emitted from the semiconductor light emitting device.

As a projection device of this type, Patent Literature (PTL) 1 discloses a light emitting device which includes a semiconductor laser element and a phosphor. The following describes conventional light emitting device 1001 disclosed by PTL 1, with reference to FIG. 41.

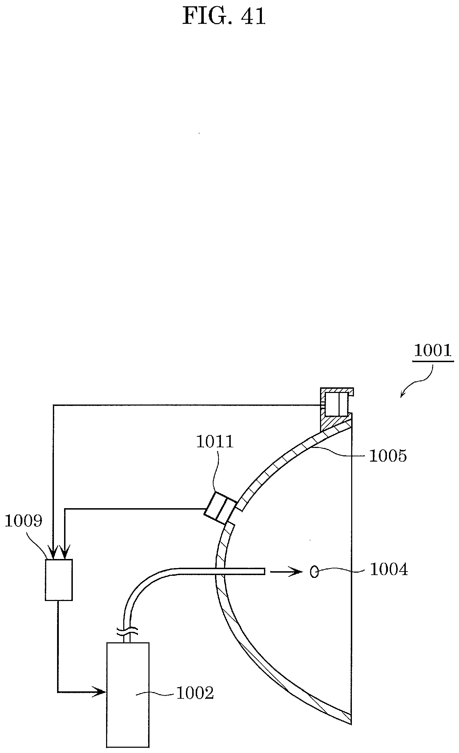

FIG. 41 is a diagram for explaining a configuration of conventional light emitting device 1001.

As illustrated in FIG. 41, conventional light emitting device 1001 includes semiconductor laser element 1002 which oscillates laser light, phosphor 1004 which converts at least a portion of the laser light oscillated from semiconductor laser element 1002 into incoherent light, reflector plate 1005 which reflects light emitted from phosphor 1004, and safety devices (photodetector 1011 and control unit 1009) which inhibit emission of coherent laser light to the outside.

Blue laser light emitted from semiconductor laser element 1002 is wavelength-converted into light having a wavelength greater than 500 nm and emitted by phosphor 1004. At this time, there are instances where phosphor 1004 is damaged or omitted, leading to abnormal deterioration of phosphor 1004. In such a case, for example, abnormal light conversion, such as the state where laser light is emitted to the outside as it is, occurs in some cases. In view of the above, with conventional light emitting device 1001 illustrated in FIG. 41, output of semiconductor laser element 1002 is stopped when photodetector 1011 detects a decrease in output resulting from occurrence of abnormal deterioration of phosphor 1004. More specifically, when control unit 1009 determines that an output value of light receiving element 1008 is less than or equal to a predetermined value, control unit 1009 causes driving of semiconductor laser element 1002 to stop. In this manner, it is possible to inhibit emitting of laser light to the outside.

In addition, PTL 2 proposes a device which, in a vehicular headlight using a semiconductor laser element as a light source, causes a portion of illumination light reflected by a reflective surface of a reflector that is disposed on a light path of illumination light to be incident on a photodetector, and controls the semiconductor laser element. This device is capable of controlling the semiconductor laser element such that laser light is not emitted when a component for wavelength-converting the laser light is missing.

### Citation List

### Patent Literature

PTL 1: Japanese Unexamined Patent Application Publication No. 2011-66069
PTL 2: Japanese Unexamined Patent Application Publication No. 2014-180886

### SUMMARY OF THE INVENTION

### TECHNICAL PROBLEMS

However, in the conventional projection devices (e.g., PTL 1 or PTL 2), a reflective component which is provided so as to guide light to a photodetector or the photodetector itself is disposed on an area through which light that is effective as illumination light passes, leading to a loss in an optical efficiency. As a result, the luminous flux of the projection device decreases, leading to uneveness in light intensity in an illuminated region of illumination light.

In addition, with the configurations of the conventional projection devices (e.g., PTL 1 or PTL 2), light in an external environment is likely to enter a photodetector, and thus it is difficult to accurately detect abnormal light conversion due to abnormal deterioration of a wavelength conversion component (phosphor, etc.).

The present disclosure has been conceived to solve such problems as described above. An object of the present disclosure is to provide a light source device and a projection device which are capable of accurately detecting abnormal deterioration of a wavelength conversion component using a photodetector, as well as inhibiting, even when a photodetector is used, occurrence of uneveness in light intensity in an illuminated region of illumination light due to the photodetector.

### SOLUTIONS TO PROBLEMS

In order to solve the above-described problems, an aspect of a light source device according to the present disclosure is a light source device which includes: a semiconductor light emitting device which emits laser light; a wavelength conversion component which emits fluorescence by being irradiated with the laser light emitted from the semiconductor light emitting device as excitation light; and a photodetector on which a portion of light emitted from the wavelength conversion component is incident. In the light source device, the photodetector is disposed at a location off a light path of usable radiation light which is emitted from the wavelength conversion component to a space and used as illumination light.

With this configuration, it is possible to accurately detect abnormal deterioration of a wavelength conversion component using a photodetector, as well as possible to inhibit, even when the photodetector is used, occurrence of uneveness in light intensity in an illuminated region of illumination light due to the photodetector. Furthermore, since it is possible to implement a light source device which is small in size, a projection device which includes the light source device can be small in size as well.

In addition, in an aspect of the light source device according to the present disclosure, the light source device may further include: a first reflective component which reflects a portion of light which is emitted from the wavelength conversion component and not used as illumination light, in a direction away from a direction of travel of the usable radiation light. In the light source device, light reflected by the first reflective component may be incident on the photodetector.

With this configuration, it is possible to cause light which is emitted from the wavelength conversion component and not used as illumination light (unnecessary light) to be easily incident on the photodetector.

In addition, in an aspect of the light source device according to the present disclosure, a light-transmissive component may further be disposed on the light path of the usable radiation light.

With this configuration, since a transparent cover for the purpose of preventing attachment of dirt or dust to the photodetector is used as the transparent component, there is no loss in optical efficiency resulting only from guiding light to the photodetector.

Alternatively, in an aspect of the light source device according to the present disclosure, a light-transmissive component may further be disposed on the light path of the usable radiation light. In the light source device, the light-transmissive component may function as the first reflective component.

With this configuration, it is possible to reflect a portion of light (unnecessary light) which is not used as illumination light, and guide the portion of light to the photodetector, without using a reflective component.

In addition, in an aspect of the light source device according to the present disclosure, a supporting component which supports the wavelength conversion component may be further included. In the light source device, the light-transmissive component may close an opening of the supporting component.

With this configuration, it is possible to protect the wavelength conversion component supported by the supporting component.

Alternatively, in an aspect of the light source device according to the present disclosure, a supporting component which supports the wavelength conversion component and a circuit board attached to the supporting component may further be included. In the light source device, the semiconductor light emitting device and the photodetector may be disposed on the circuit board.

With this configuration, it is possible to easily mount the semiconductor light emitting device and the photodetector on the circuit board. Accordingly, it is possible to easily manufacture the light source device.

In addition, in an aspect of the light source device according to the present disclosure, the supporting component may have an opening portion through which light incident on the photodetector passes.

With this configuration, it is possible to guide light emitted from the wavelength conversion component to the photodetector through the opening portion.

In addition, in an aspect of the light source device according to the present disclosure, the supporting component may have a recess which is continuous with the opening portion, and the photodetector may be disposed in the recess.

With this configuration, it is possible to cause only an intended portion of light to be incident on the photodetector as well as possible to protect the photodetector.

In addition, in an aspect of the light source device according to the present disclosure, a temperature detection element may further be disposed in the recess at position between the semiconductor light emitting device and the photodetector.

With this configuration, it is possible to detect a temperature in proximity to the semiconductor light emitting device by the temperature detection element. Accordingly, it is possible to determine whether or not the wavelength conversion component is abnormally deteriorated, in consideration of temperature dependency of light emission of the semiconductor light emitting device. Accordingly, it is possible to further accurately detect abnormal deterioration of the wavelength conversion component.

In addition, in an aspect of the light source device according to the present disclosure, the circuit board to which the semiconductor light emitting device and the photodetector are attached may be a single circuit board, and the light source device may further include a controller which is attached to the single circuit board. The controller controls the semiconductor light emitting device based on an intensity of light incident on the photodetector.

With this configuration, it is possible to implement a light source device which is smaller in size, as well as the light source device can perform itself a safety function of preventing laser light emitted from the semiconductor light emitting device from exiting directly to the outside, without using an external control outside the light source device.

In addition, in an aspect of the light source device according to the present disclosure, the controller may cancel a change in light emission of the semiconductor light emitting device due to an environmental temperature, and detect abnormal deterioration of the wavelength conversion component based on a variation in a rate of change of output of the photodetector.

With this configuration, since it is possible to ignore the influence of a change in light emission due to temperature dependency of the semiconductor light emitting device, it is possible to further accurately detect abnormal deterioration of the wavelength conversion component.

Alternatively, in an aspect of the light source device according to the present disclosure, unnecessary light included in laser light emitted from the semiconductor light emitting device and reflected by the wavelength conversion component may be incident on the photodetector, and the controller may detect an abnormal deterioration of the wavelength conversion component based on a signal from the photodetector.

In this manner, it is possible to easily detect abnormal deterioration of the wavelength conversion component.

In addition, in an aspect of the light source device according to the present disclosure, light which travels in a direction away from a direction of travel of the usable radiation light may be incident on the photodetector.

In this manner, it is possible to detect abnormal deterioration of the wavelength conversion component without causing a decrease in utilization efficiency of illumination light emitted from the light source device.

In addition, in an aspect of the light source device according to the present disclosure, a second reflective component which reflects laser light emitted from the semiconductor light emitting device may further be included. In the light source device, the wavelength conversion component may emit the usable radiation light from a face on which the laser light reflected by the second reflective component is incident.

With this configuration, it is possible to implement a light source device of a reflection type of which excitation light is reflected by the wavelength conversion component and becomes radiation light.

In addition, in an aspect of the light source device according to the present disclosure, the wavelength conversion component may emit the usable radiation light from a face opposite to a face on which the laser light is incident.

With this configuration, it is possible to implement a light source device of a transmissive type of which excitation light is transmitted through the wavelength conversion component and becomes radiation light.

In addition, in an aspect of the light source device according to the present disclosure, an optical element may be included between the semiconductor light emitting device and the wavelength conversion component. The optical element condenses the laser light.

With this configuration, it is possible to cause laser light emitted from the semiconductor light emitting device to be illuminated to an intended illumination area of the wavelength conversion component.

In addition, an aspect of a projection device according to the present disclosure includes: a light source device; and a projection component which reflects usable radiation light emitted from the light source device. In the projection device, the light source device includes: a semiconductor light emitting device which emits laser light; a wavelength conversion component which emits fluorescence by being irradiated with the laser light emitted from the semiconductor light emitting device as excitation light; and a photodetector on which a portion of light emitted from the wavelength conversion component is incident, and the photodetector is disposed at a location off a light path of the usable radiation light included in light emitted from the wavelength conversion component to a space.

With this configuration, it is possible to accurately detect abnormal deterioration of the wavelength conversion component as well as possible to inhibit occurrence of uneveness in the light intensity in an illuminated region of illumination light. In addition, use of a light source device which is small in size makes it possible to implement a projection device which is small in size and has excellent reliability.

In addition, in an aspect of a projection device according to the present disclosure, the light source device may include: a supporting component which supports the wavelength conversion component; and a circuit board attached to the supporting component, and the circuit board may include an external connecting component on a side opposite to a side to which light reflected by the projection component travels.

With this configuration, it is possible to simplify electric wiring of the projection device.

In addition, in an aspect of the projection device according to the present disclosure, the light source device may include: a supporting component which supports the wavelength conversion component; and a heat dissipation component attached to the supporting component, and the heat dissipation component may include a cooling fin on a side opposite to a side to which light reflected by the projection component travels.

With this configuration, it is possible to easily dissipate heat generated in the light source device to the outside (e.g., to the atmosphere), without restricting a light path of usable radiation light in the projection device.

In addition, in an aspect of the projection device according to the present disclosure, the light source device may include a second reflective component which reflects laser light emitted from the semiconductor light emitting device, toward the wavelength conversion component, and the laser light reflected by the second reflective component may travel in a direction opposite to a direction in which light reflected by the projection device travels.

With this configuration, even when the wavelength conversion component is damaged during the operation of the light source device, it is possible to inhibit radiation light which is high in directivity and an energy density from being emitted to a component of the projection device and directly emitted to the outside. Accordingly, it is possible to enhance safety of the projection device.

### ADVANTAGEOUS EFFECTS OF INVENTION

According to the present disclosure, it is possible to accurately detect abnormal deterioration of a wavelength conversion component using a photodetector, as well as possible to inhibit, even when the photodetector is used, occurrence of uneveness in the light intensity in an illuminated region of illumination light due to the photodetector.

### BRIEF DESCRIPTION OF DRAWINGS

FIG. 1 is a schematic cross-sectional diagram which illustrates a configuration of a light source device according to Embodiment 1.
FIG. 2 is a circuit block diagram which illustrates a circuit configuration of the light source device according to Embodiment 1, and a circuit configuration of a driving unit for driving the light source device.
FIG. 3 is a schematic diagram for explaining a function of a lamp and a vehicle which include the light source device according to Embodiment 1.
FIG. 4 is a timing chart of each of signals of a controller included in the light source device according to Embodiment 1.
FIG. 5A is a diagram which illustrates a relationship between utilization efficiency of light and the maximum capturing angle corresponding to the numerical aperture of a projection component, when radiation light is emitted from the light source device to a projection component.
FIG. 5B is a diagram which indicates dependence of the light intensity of first radiation light of the light source device according to Embodiment 1, on an angle from the optical axis.
FIG. 5C is a diagram which indicates dependence of the light intensity of second radiation light of the light source device according to Embodiment 1, on an angle from the optical axis.
FIG. 6 is a diagram for explaining a change in a shape and a change in radiation light of a wavelength conversion component of the light source device according to Embodiment 1.
FIG. 7 is a diagram which corresponds to FIG. 6 and indicates dependence of light intensity of the first radiation light, on an angle from the optical axis.
FIG. 8 is a diagram which corresponds to FIG. 6 and indicates dependence of light intensity of the second radiation light, on an angle from the optical axis.
FIG. 9 is a timing chart of each of signals of a controller included in the light source device according to Embodiment 1.
FIG. 10 is a timing chart of each of signals of a controller included in a light source device according to a variation example of Embodiment 1.
FIG. 11 is a schematic cross-sectional diagram which illustrates a configuration of a light source device according to Embodiment 2.
FIG. 12 is a cross-sectional diagram which illustrates a more detailed configuration of the light source device according to Embodiment 2.
FIG. 13 is a diagram for explaining a method of manufacturing the light source device according to Embodiment 2.
FIG. 14 is a diagram for explaining the method of manufacturing the light source device according to Embodiment 2.
FIG. 15 is a schematic cross-sectional diagram which illustrates a configuration of a first lamp including the light source device according to Embodiment 2.
FIG. 16 is a schematic cross-sectional diagram which illustrates a configuration of a second lamp including the light source device according to Embodiment 2.
FIG. 17 is a schematic cross-sectional diagram which illustrates a configuration of a third lamp including the light source device according to Embodiment 2.
FIG. 18 is a schematic cross-sectional diagram which illustrates a configuration of a light source device according to Embodiment 3.
FIG. 19 is a circuit block diagram which illustrates a circuit configuration of the light source device according to Embodiment 3 and a circuit configuration of a driving unit for driving the light source device.
FIG. 20 is a timing chart of each of signals of a controller included in the light source device according to Embodiment 3.
FIG. 21 is a schematic cross-sectional diagram which illustrates a configuration of a light source device according to a variation example of Embodiment 3.
FIG. 22 is a diagram for explaining a change in a shape and a change in radiation light of a wavelength conversion component of the light source device according to the variation example of Embodiment 3.
FIG. 23 is a schematic cross-sectional diagram which illustrates a configuration of a light source device according to Embodiment 4.
FIG. 24 is a circuit block diagram which illustrates a circuit configuration of the light source device according to Embodiment 4 and a circuit configuration of a driving unit for driving the light source device.
FIG. 25 is a schematic cross-sectional diagram which illustrates a configuration of a light source device according to Embodiment 5.
FIG. 26 is a diagram for explaining a method of manufacturing the light source device according to Embodiment 5.
FIG. 27 is a schematic cross-sectional diagram which illustrates a configuration of a light source device according to Embodiment 6.
FIG. 28 is a schematic cross-sectional diagram which illustrates a configuration of a light source device according to Embodiment 7.
FIG. 29 is a schematic cross-sectional diagram which illustrates a configuration of a light source device according to Embodiment 8.
FIG. 30 is a diagram for explaining a safety function of the light source device according to Embodiment 8.
FIG. 31 is a schematic cross-sectional diagram which illustrates a configuration of a light source device according to a variation example of Embodiment 8.
FIG. 32 is a diagram which illustrates a positional relationship between a wavelength conversion component, a transparent cover component, and a photodetector of the light source device according to the variation example of Embodiment 8.
FIG. 33A is a diagram which illustrates a positional relationship between a wavelength conversion component, a transparent cover component, and a photodetector of a light source device according to Comparison 1.
FIG. 33B is a diagram which illustrates a positional relationship between a wavelength conversion component, a transparent cover component, and a photodetector of a light source device according to Comparison 2.
FIG. 34 is a schematic cross-sectional diagram which illustrates a configuration of a light source device according to Embodiment 9.
FIG. 35 is a circuit block diagram which illustrates a circuit configuration of the light source device according to Embodiment 9 and a circuit configuration of a driving unit for driving the light source device.
FIG. 36 is a schematic cross-sectional diagram which illustrates a configuration of a light source device according to a variation example of Embodiment 9.
FIG. 37 is a schematic cross-sectional diagram which illustrates a configuration of a light source device according to Embodiment 10.
FIG. 38 is a diagram for explaining a safety function of the light source device according to Embodiment 10.
FIG. 39 is a diagram for explaining a safety function of the light source device according to Embodiment 10.
FIG. 40 is a timing chart of each of signals of a controller included in a light source device according to a variation example.
FIG. 41 is a cross-sectional diagram which illustrates a configuration of a conventional light source device.

### DESCRIPTION OF EXEMPLARY EMBODIMENTS

Hereinafter, embodiments of the present disclosure will be described in detail with reference to the drawings. It should to be noted that each of the embodiments described below shows a specific example. Thus, the numerical values, structural components, the disposition and connection of the structural components, processes (steps), the processing order of the steps, and others described in the following embodiments are mere examples, and do not intend to limit the present disclosure. Furthermore, among the structural components in the following embodiments, components not recited in the independent claims which indicate the broadest concepts of the present disclosure are described as arbitrary structural components.

In addition, each diagram is a schematic diagram and not necessarily strictly illustrated. In each of the diagrams, substantially the same structural components are assigned with the same reference signs, and redundant descriptions will be omitted or simplified. In other words, descriptions for the structural components which are common among the diagrams will be omitted or simplified.

### (Embodiment 1)

The following describes light source device 101 according to Embodiment 1 of the present disclosure.

### (Configuration)

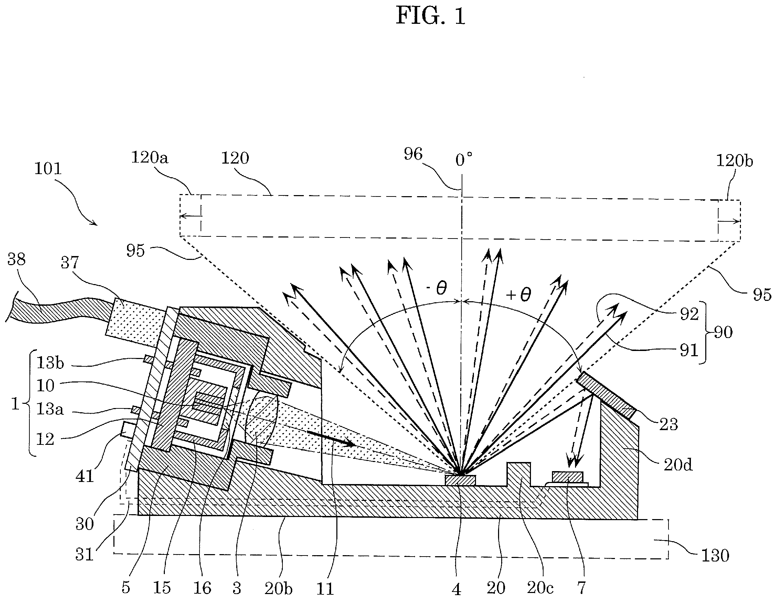

First, a configuration of light source device 101 according to Embodiment 1 shall be described with reference to FIG. 1. FIG. 1 is a schematic cross-sectional view which illustrates a configuration of light source device 101 according to Embodiment 1.

As illustrated in FIG. 1, light source device 101 includes semiconductor light emitting device 1, wavelength conversion component 4, and photodetector 7. According to the present embodiment, light source device 101 further includes condenser lens 3, supporting component 20, and reflective component 23. Light source device 101 is, for example, attached to heat dissipation component 130, and emits illumination light to projection component 120 such as a projection lens.

Emission light 11 emitted from semiconductor light emitting device 1 is condensed by condenser lens 3 and emitted onto wavelength conversion component 4, and light generated by wavelength conversion component 4 is emitted to a space as radiation light 90 of light source device 101. A portion of radiation light 90 is emitted to the outside as illumination light of light source device 101.

In light source device 101, semiconductor light emitting device 1 is connected to first wiring board 30. Semiconductor light emitting device 1 includes semiconductor light emitting element 10 and package 12 on which semiconductor light emitting element 10 is mounted. Package 12 is a TO-CAN package, for example. Package 12 is provided with: a pair of lead pins 13a and 13b which are interconnecting lines for applying power to semiconductor light emitting element 10; and can 15 to which light-transmissive component 16 such as flat glass is attached. Light-transmissive component 16 transmits emission light 11 emitted from semiconductor light emitting element 10. Semiconductor light emitting element 10 is disposed in an enclosed space enclosed by package 12 and can 15.

Semiconductor light emitting element 10 included in semiconductor light emitting device 1 is, for example, a nitride semiconductor light emitting element including a light emitting layer of a nitride semiconductor. According to the present embodiment, semiconductor light emitting element 10 is a semiconductor laser diode element on which an optical waveguide is formed. Accordingly, semiconductor light emitting device 1 emits laser light as emission light 11. Emission light 11 emitted from semiconductor light emitting element 10 is light having a wavelength from near-ultraviolet to blue, with a peak wavelength between 380 nm to 490 nm, for example. According to the present embodiment, blue laser light having a peak wavelength of 450 nm, for example, is emitted as emission light 11 from semiconductor light emitting element 10. Emission light 11 is transmitted through light-transmissive component 16 and emitted to the outside of semiconductor light emitting device 1.

Lead pins 13a and 13b of semiconductor light emitting device 1 are connected to first wiring board 30. First wiring board 30 is, for example, a printed wiring board including a line formed using copper foil or the like on a board including glass epoxy. A connector, for example, is mounted on first wiring board 30, as external connecting member 37. In addition, a cable for electric connection, for example, is connected as external line 38 to external connecting member 37. Power supplied from external line 38 is supplied to first wiring board 30 via external connecting member 37. In this manner, power is supplied to semiconductor light emitting device 1 via lead pins 13a and 13b, causing semiconductor light emitting device 1 to emit light.

Condenser lens 3 is an optical component having a function of condensing emission light 11 emitted from semiconductor light emitting device 1 to wavelength conversion component 4, and disposed between semiconductor light emitting device 1 and wavelength conversion component 4.

Condenser lens 3 is formed of an optical system including an optical component such as one or more convex lenses or concave reflection lenses, and condenses part or all of emission light 11 to part or all of the surface of wavelength conversion component 4. Condenser lens 3 is disposed at a position facing light-transmissive component 16, and held, for example, by lens holder 5 fixed to supporting component 20. According to the present embodiment, condenser lens 3 is a convex lens. Use of condenser lens 3 makes it possible to cause emission light 11 emitted from semiconductor light emitting device 1 to be emitted to an intended illumination area of wavelength conversion component 4.

Wavelength conversion component 4 is a phosphor optical element including a phosphor material of at least one type, for example. In this case, wavelength conversion component 4 produces fluorescence using incident light as excitation light. In other words, emission light 11 emitted from semiconductor light emitting device 1 is emitted to wavelength conversion component 4 as excitation light, and thereby wavelength conversion component 4 emits fluorescence. Wavelength conversion component 4, for example, absorbs light having a wavelength from 380 nm to 490 nm, and emits fluorescence having at least one peak wavelength in a range of visible light having a wavelength from 420 nm to 780 nm.

According to the present embodiment, wavelength conversion component 4 includes a phosphor. Wavelength conversion component 4, for example, at least includes a phosphor which emits light in a wavelength band of at least from yellow light to red light having a wavelength from 500 nm to 650 nm. As a phosphor, for example, a cerium-activated (Ce-activated) yttrium aluminum garnet (YAG)-based phosphor or the like can be used.

Radiation light 90 is light emitted from wavelength conversion component 4 toward a space. Part or all of emission light 11 emitted from semiconductor light emitting device 1 is absorbed by wavelength conversion component 4. Accordingly, radiation light 90 is emitted from wavelength conversion component 4 as light including light having a wavelength different from a wavelength of emission light 11. According to the present embodiment, radiation light 90 is emitted toward a space external to light source device 101. More specifically, radiation light 90 is emitted from a face of wavelength conversion component 4 on which emission light 11 is incident.

Radiation light 90 is, for example, light in which first radiation light 91 and second radiation light 92 are mixed. A portion of emission light 11 which is not absorbed by wavelength conversion component 4 and is scattered to be irradiated is first radiation light 91. Another portion of emission light 11 which is absorbed by wavelength conversion component 4 and emitted as fluorescence is second radiation light 92. For example, when emission light 11 emitted from semiconductor light emitting device 1 is blue light and a material of wavelength conversion component 4 is a yellow phosphor, first radiation light 91 is blue light and second radiation light 92 is yellow light, and white light resulting from mixing blue light and yellow light together is emitted as radiation light 90.

Photodetector 7 is a photodiode, for example, and receives a portion of light emitted from wavelength conversion component 4. In other words, a portion of light emitted from wavelength conversion component 4 is incident on photodetector 7. According to the present embodiment, photodetector 7 receives light emitted from, among the surfaces of wavelength conversion component 4, the surface on which emission light 11 is incident.

Photodetector 7 is disposed at a location off a light path of light which is emitted from wavelength conversion component 4 and used as illumination light (usable radiation light). According to the present embodiment, photodetector 7 receives light which is a portion of radiation light 90 emitted from wavelength conversion component 4, and is not incident on projection component 120. More specifically, light which is incident on photodetector 7 is light that is not used as illumination light under ordinary circumstances (unnecessary light), and photodetector 7 receives the unnecessary light. In other words, light which is not incident on projection component 120 is utilized, and the light is caused to enter photodetector 7.

Photodetector 7 is connected to second wiring board 31. Second wiring board 31 is, for example, a flexible printed circuit including a line formed using copper foil or the like on a base film formed using polyimide, etc. Second wiring board 31 is connected to first wiring board 30. Resistive element 41, etc. may be mounted on first wiring board 30, as an electronic component for converting current generated when photodetector 7 receives light into a voltage. It is possible to determine a state of wavelength conversion component 4 based on a change in output of photodetector 7 that corresponds to an amount of light received by photodetector 7. For example, when output of photodetector 7 decreases, it is possible to determine that wavelength conversion component 4 is deteriorated.

Supporting component 20 is a supporting base for supporting wavelength conversion component 4, and includes a metal material such as aluminum, for example. Wavelength conversion component 4 is supported by supporting component 20. According to the present embodiment, supporting component 20 supports not only wavelength conversion component 4 but also semiconductor light emitting device 1, photodetector 7, reflective component 23, and first wiring board 30. In addition, semiconductor light emitting device 1 is supported by supporting component 20 via lens holder 5.

Supporting component 20 has a face that is heat dissipation surface 20b facing heat dissipation component 130. Heat generated in semiconductor light emitting device 1 and wavelength conversion component 4 are dissipated from heat dissipation surface 20b to heat dissipation component 130. In this case, supporting component 20 may include separation wall 20c for separating wavelength conversion component 4 from photodetector 7.

Reflective component 23 (the first reflective component) reflects a portion of light emitted from wavelength conversion component 4, in a direction away from a direction of travel of light which is emitted from wavelength conversion component 4 and used as illumination light (usable radiation light). More specifically, reflective component 23 reflects a portion of light of radiation light 90 emitted from wavelength conversion component 4, and guides the portion of light to photodetector 7. In other words, light reflected by reflective component 23 is incident on photodetector 7. Reflective component 23 is fixed to holding portion 20d of supporting component 20, and is thereby supported by supporting component 20.

With light source device 101 configured in this manner, emission light 11 emitted from semiconductor light emitting device 1 is emitted to wavelength conversion component 4, and radiation light 90 is emitted from wavelength conversion component 4.

As described above, light which is a portion of radiation light 90 and emitted toward projection component 120 is usable radiation light which is used as illumination light of light source device 101, and is light which is incident on projection component 120. Meanwhile, a portion of unnecessary light which is: a portion of radiation light 90; not emitted toward projection component 120; and not used as illumination light is incident on photodetector 7.

It should be noted that, in FIG. 1, usable radiation range 95 indicates a range of light which is incident on projection component 120. In addition, in FIG. 1, region 120a and region 120b indicated by dashed lines each indicate a range which radiation light 90 emitted from light source device 101 can be incident on even when projection component 120 is displaced. In other words, regions 120a and region 120b each indicate a maximum range of usable radiation range 95.

### (Circuit)

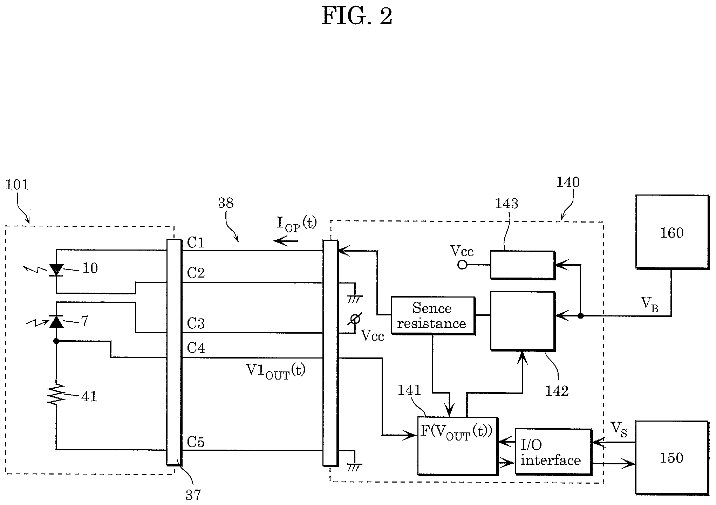

The following describes a circuit of light source device 101 according to Embodiment 1, with reference to FIG. 2. FIG. 2 is a circuit block diagram which illustrates a circuit configuration of light source device 101 according to Embodiment 1, and a circuit configuration of a driving unit for driving light source device 101.

As illustrated in FIG. 2, light source device 101 includes semiconductor light emitting element 10, photodetector 7, external connecting member 37, and resistive element 41, each of which is connected as illustrated in FIG. 2.

Resistive element 41 converts current generated when photodetector 7 receives light into a voltage, as described above. External connecting member 37 includes: anode terminal C1; cathode terminal C2; first power supply terminal C3; first signal terminal C4; and first ground terminal C5. External connecting member 37 is connected to controller 140 via external line 38.

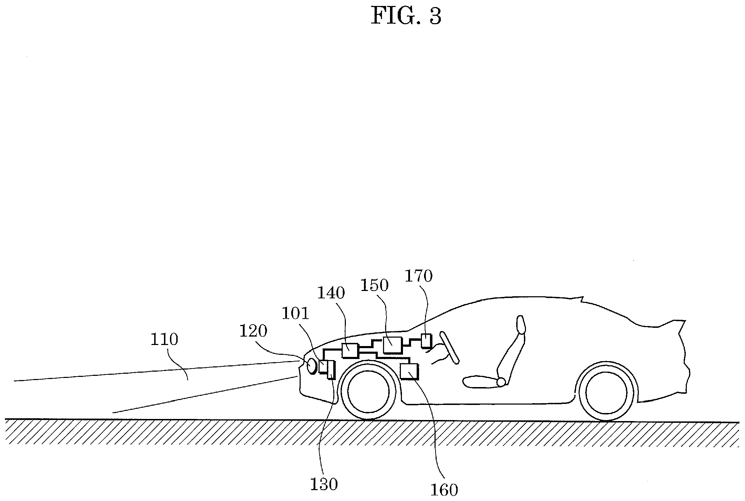

The driving unit of light source device 101 includes: power supply 160 which is, for example, a battery; external circuit 150 which is, for example, a central control unit; and controller 140. Power supply 160, external circuit 150, and controller 140 are, for example, mounted on a vehicle such as an automobile, as illustrated in FIG. 3. It should be noted that FIG. 3 is a schematic cross-sectional view for explaining functions of a headlight (lamp) which includes light source device 101 according to Embodiment 1, and an automobile which includes the headlight.

As illustrated in FIG. 2, controller 140 supplies, to semiconductor light emitting element 10, current for driving semiconductor light emitting element 10 using anode terminal C1 and cathode terminal C2 of external connecting member 37. In addition, controller 140 supplies also power to photodetector 7, and receives a signal generated by photodetector 7 and resistive element 41. Controller 140 controls semiconductor light emitting device 1 based on an intensity of light (amount of received light) incident on photodetector 7. Power supply 160 supplies voltage V_{B} as source power to controller 140. External circuit 150 performs communication with, for example, controller 140, to obtain information from controller 140 or give an instruction to controller 140.

### (Operation)

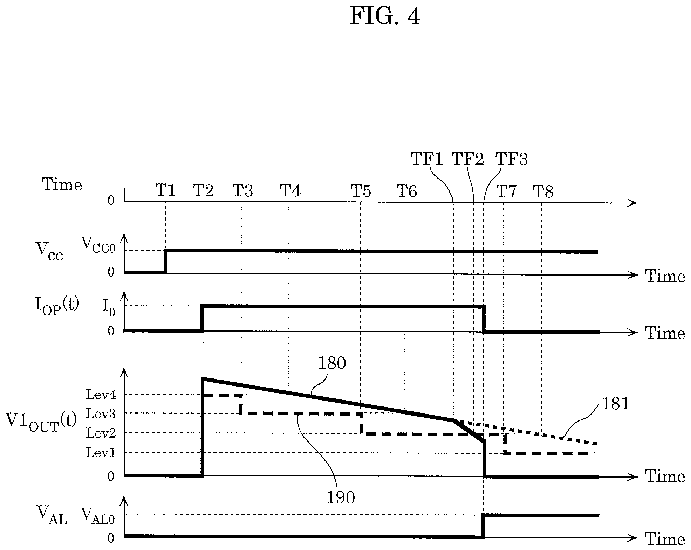

The following describes an operation of light source device 101 according to Embodiment 1, on the basis of an example of actual experiments, etc., with reference to FIG. 4 in view of FIG. 2 and FIG. 3. FIG. 4 is a timing chart of each signal of controller 140 included in light source device 101 according to Embodiment 1. It should be noted that FIG. 4 illustrates an example when, among first radiation light 91 (blue light) and second radiation light 92 (yellow light), only second radiation light 92 (yellow light) is received by photodetector 7. Receiving only second radiation light 92 by photodetector 7 can be made possible by appropriately disposing a cut filter for cutting a wavelength of first radiation light 91 in front of photodetector 7, or using a filter which mainly reflects second radiation light 92 as reflective component 23.

When performing preparation for operation of light source device 101 by, for example, starting up an engine of the vehicle illustrated in FIG. 3, power is supplied from power supply 160 to controller 140 as illustrated in FIG. 2, and a predetermined voltage is applied to power supply voltage V_{cc} by step-down circuit 143 that is a first back converter. At this time, voltage V_{cc0} is applied to power supply voltage V_{cc} at time T1 as illustrated in FIG. 4.

Next, as illustrated in FIG. 2, a predetermined instruction signal (Vs) is transmitted from external circuit 150 to microcontroller 141. This causes predetermined current Iₒₚ(t) to flow from step-down circuit 142 that is a second back converter to anode terminal C1 of external connecting member 37 through external line 38. At this time, current that is Iₒₚ(t) = I_{ο} flows at time T2 as illustrated in FIG. 4. At this time, a sense resistance is used to monitor a current amount and set current Iₒₚ(t) to an accurate value.

As illustrated in FIG. 2, current Iₒₚ(t) from anode terminal C1 is supplied from external line 38 to external connecting member 37. Then, current Iₒₚ(t) is supplied from first wiring board 30 to lead pins 13a and 13b as illustrated in FIG. 1, and supplied to semiconductor light emitting element 10 via a metal wire which is not illustrated in the diagrams. Current Iₒₚ(t) supplied to semiconductor light emitting element 10 is converted to optical energy, and emission light 11 is emitted from semiconductor light emitting element 10.

As illustrated in FIG. 1, emission light 11 emitted from semiconductor light emitting element 10 (semiconductor light emitting device 1) is condensed by condenser lens 3 and incident on wavelength conversion component 4. Wavelength conversion component 4 scatters a portion of emission light 11 and emits first radiation light 91, and absorbs another portion of emission light 11 and emits second radiation light 92. Then, first radiation light 91 and second radiation light 92 are mixed and emitted from light source device 101 as radiation light 90.

At this time, a portion of radiation light 90 is reflected by reflective component 23 and incident on photodetector 7. Light which is incident on photodetector 7 is converted to voltage signal V1_{OUT}(t) by a photoelectric conversion element and resistive element 41, and voltage signal V1_{OUT}(t) is outputted from first signal terminal C4 as illustrated in FIG. 2 and inputted to microcontroller 141 of controller 140.

At this time, voltage signal V1_{OUT}(t) inputted to microcontroller 141 is, for example, signal 180 which is a voltage signal that is converted over time as illustrated in FIG. 4. Signal 180 is a signal which decreases over time from time T2 to time TF1 according to a decrease in output of radiation light 90 due to continuous energization of light source device 101, and decreases at a constant rate as illustrated by signal 181 indicated by a dashed line when there is no damage etc. of wavelength conversion component 4.

Accordingly, as a comparison signal for detecting abnormal deterioration of wavelength conversion component 4 due to damage or the like of wavelength conversion component 4, a voltage value which changes according to time, as threshold signal 190 in FIG. 4, can be used. According to the present embodiment, in consideration of aging deterioration of wavelength conversion component 4, threshold signal 190 is set to a value which decreases over time in a staircase pattern. More specifically, as illustrated in FIG. 4, for example, threshold signal is at Lev4 from time T2 to time T3, and at Lev3 from time T3 to time T5.

In the case where signal 180 is lower than threshold signal 190 when threshold signal 190 and signal 180 are compared (time TF2 in FIG. 4), microcontroller 141 determines that abnormal deterioration has occurred in wavelength conversion component 4, and causes current I_{OP}(t) to be zero by controlling step-down circuit 142 to stop the operation of semiconductor light emitting device 1.

It should be noted that, as illustrated in FIG. 4, for example, voltage V_{AL} that is an alert signal is set to a predetermined voltage V_{AL0}, and a signal is transmitted to external circuit 150 as illustrated in FIG. 3, so as to cause warning lamp 170 to display a warning signal, simultaneously with stopping the operation of semiconductor light emitting device 1.

In this manner, with a method of detecting an abnormality of light source device 101 according to the present embodiment, abnormal deterioration of wavelength conversion component 4 due to damage or the like of wavelength conversion component 4 is detected according to signal 180 which is based on output of photodetector 7, in consideration of aging deterioration of wavelength conversion component 4. More specifically, controller 140 causes threshold signal 190 to change according to operation time of semiconductor light emitting device 1, and compares threshold signal 190 and signal 180 based on output of photodetector 7, thereby determining abnormal deterioration of wavelength conversion component 4. In this manner, it is possible to accurately detect abnormal deterioration of wavelength conversion component 4 caused not by aging deterioration of wavelength conversion component 4 but by damage or the like of wavelength conversion component 4.

The following describes the influence on wavelength conversion component 4 exerted by emission light 11 emitted from semiconductor light emitting device 1 in light source device 101, based on an actual design and an example of experiments.

Radiation light 90 emitted by light source device 101 is used as illumination light 110 according to a numerical aperture (NA) of projection component 120 (lens) as illustrated in FIG. 1.

Increasing of the brightness of illumination light 110 depends on the performance of projection component 120. In this case, it is possible to increase the utilization efficiency of light by increasing the numerical aperture of projection component 120. More specifically, as a lens which is large in the numerical aperture, for example, a lens having the numerical aperture (NA) of 0.85 (the maximum capturing angle is approximately 58 degrees) which is developed for Blu-ray (registered trademark) or the like can be used.

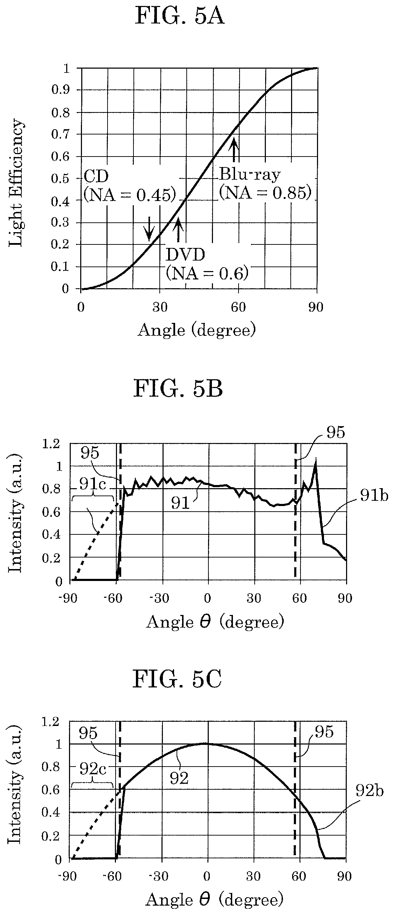

FIG. 5A is a diagram which illustrates a relationship between the utilization efficiency of light and the maximum capturing angle corresponding to the numerical aperture of projection component 120, when it is assumed that radiation light 90 emitted by light source device 101 is emitted in a Lambertian light distribution.

As illustrated in FIG. 5A, it is possible to utilize greater than or equal to approximately 70% of light, by using a lens having the numerical aperture NA that is 0.85 as projection component 120. It should be noted that, with a lens for a CD (NA = 0.45), only approximately 20% of light can be utilized. In addition, with a lens for a DVD (NA = 0.6), only approximately 30% of light can be utilized.

Based on the above-described results, a prototype of light source device 101 was prepared, and radiation directions of radiation light 90 and arrangement of photodetector 7 were examined. The following describes the result of the examination.

In this examination, semiconductor light emitting device 1 which emits emission light 11 having a peak wavelength of 450 nm is used, and a YAG phosphor is used as wavelength conversion component 4. The light intensity of radiation light 90 was measured under conditions that, as illustrated in FIG. 1, the direction perpendicular to the surface of wavelength conversion component 4 is optical axis 96, and an angle (±θ) inclined with respect to optical axis 96 is an output angle.

In addition, an incident angle of emission light 11 to wavelength conversion component 4 was set to minus 70 degrees with respect to optical axis 96. In other words, an angle formed between the incident direction in which emission light 11 is incident on and the surface of wavelength conversion component 4 was set to 20 degrees (θ = 70 degrees). The numerical aperture of projection component 120 which radiation light 90 emitted by light source device 101 is incident on was set to NA = 0.85. In this case, usable radiation range 95 is -58 degrees ≤ θ ≤ +58 degrees.

It should be noted that, a light source device resulting from removing holding portion 20d and reflective component 23 from light source device 101 illustrated in FIG. 1 was used as light source device 101.

In measuring the light intensity of radiation light from light source device 101 (i.e., radiation light from wavelength conversion component 4) at this time, radiation light of light intensity distribution having an angle dependence indicated in FIG. 5B and FIG. 5C was measured. FIG. 5B and FIG. 5C are diagrams each of which indicates dependence of light intensity of radiation light of light source device 101 according to Embodiment 1, on an angle to the optical axis. FIG. 5B indicates an angle dependence of first radiation light 91 and FIG. 5C indicates an angle dependence of second radiation light 92.

As illustrated in FIG. 5B, first radiation light 91 was scattered by wavelength conversion component 4 in usable radiation range 95 (-58 degrees ≤ θ ≤ +58 degrees), and radiation light close to the Lambertian light distribution was observed.

In addition, as to first radiation light 91b in a range of greater angle θ (+58 degrees ≤ θ ≤ +90 degrees), a distribution having a peak, at around angle θ of 70 degrees, of radiation light that is emitted while maintaining directivity of emission light 11 was observed.

Meanwhile, first radiation light 91c that is a portion of radiation light emitted toward semiconductor light emitting device 1 is blocked by supporting component 20, and thus no light intensity was observed in a range of angle θ less than -58 degrees. For that reason, in the range of angle θ less than -58 degrees, an estimated light intensity distribution is indicated by a dotted line in FIG. 5B.

As illustrated in FIG. 5C, since second radiation light 92 is light converted by a phosphor material included in wavelength conversion component 4, second radiation light 92b in the rage of angle θ greater than or equal to +58 degrees was not light of which the directivity is maintained as in first radiation light 91b illustrated in FIG. 5B.

However, in a range where angle θ is small on the side close to semiconductor light emitting device 1, second radiation light 92c which is blocked in the same manner as first radiation light 91c and has a low light intensity was observed.

According to the results of the experiment described above, radiation light 90 having angle θ greater than or equal to +58 degrees, namely, first radiation light 91b and second radiation light 92b are unnecessary light not used by projection component 120. Accordingly, utilization efficiency of illumination light that is emitted from light source device 101 through projection component 120 is not decreased by causing a portion of radiation light 90 which has angle θ greater than or equal to +58 degrees and is unnecessary light to be reflected by reflective component 23 and incident on photodetector 7. It is thus possible to detect abnormal deterioration of wavelength conversion component 4 by receiving radiation light 90 from wavelength conversion component 4 using photodetector 7, without causing a decrease in brightness of illumination light 110.

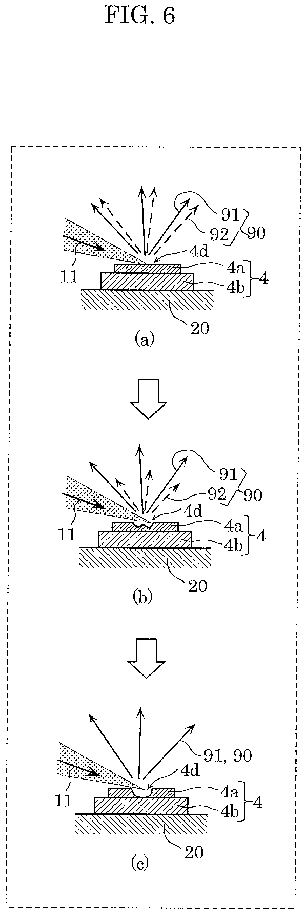

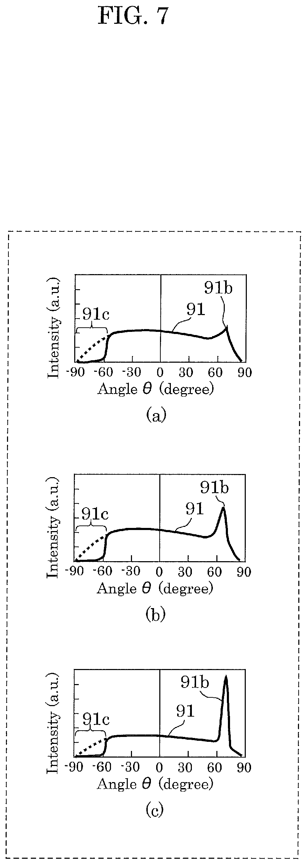

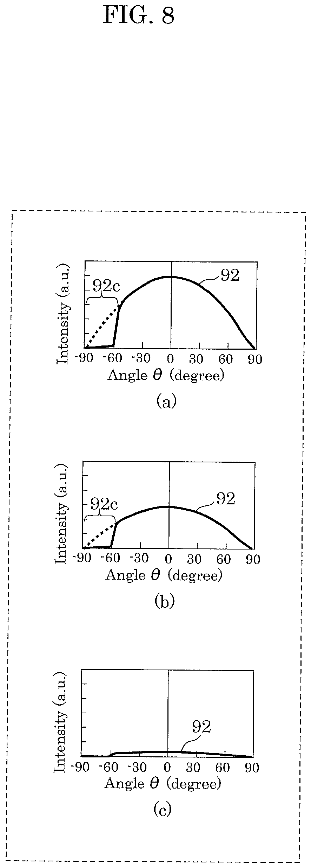

Here, a control method for accurately detecting abnormal deterioration of wavelength conversion component 4 will be described with reference to FIG. 6 to FIG. 8, while referring to the timing chart in FIG. 4. FIG. 6 is a diagram for explaining a change in the shape of wavelength conversion component 4 of light source device 101 according to Embodiment 1 and a change in radiation light. FIG. 7 and FIG. 8 are schematic diagrams each of which indicates dependence of light intensity of radiation light 90 corresponding to FIG. 6 on an angle to the optical axis. FIG. 7 indicates an angle dependence of first radiation light 91 and FIG. 8 indicates an angle dependence of second radiation light 92. It should be noted that (a), (b), and (c) of each of FIG. 7 and FIG. 8 respectively correspond to (a), (b), and (c) of FIG. 6.

Abnormal deterioration of wavelength conversion component 4 is caused by, for example, damage in wavelength conversion component 4.

In FIG. 4, it is assumed that wavelength conversion component 4 starts to be damaged at time TF1. FIG. 6 illustrates in (a) a state of wavelength conversion component 4 and neighboring portions at or before time TF1. FIG. 6 illustrates in (b) a state of wavelength conversion component 4 and neighboring portions immediately after time TF1.

Wavelength conversion component 4 includes, for example, reflective component 4b and wavelength conversion element 4a having a predetermined thickness and fixed on reflective component 4b. More specifically, a reflective component including, on a surface of a silicon substrate, a reflection film having a laminated film of a silver alloy film and a dielectric multi-layer film can be used, as reflective component 4b. In addition, a wavelength conversion element resulting from, for example, mixing a phosphor particle to a binder such as silicone, and applying and curing it on reflective component 4b with a predetermined thickness can be used as wavelength conversion element 4a.

In (a) in FIG. 6, a portion of emission light 11 which is condensed and incident on wavelength conversion element 4a is scattered by a phosphor particle of wavelength conversion element 4a, and emitted from wavelength conversion element 4a as first radiation light 91. Another portion of emission light 11 is absorbed by a phosphor particle, and emitted from wavelength conversion element 4a as second radiation light 92 which is fluorescence having a peak wavelength at or around 540 nm.

At this time, a portion of wavelength conversion element 4a in proximity to illuminated region 4d to which emission light 11 is emitted generates heat due to stokes loss that is energy loss that occurs when emission light 11 is converted to second radiation light 92, and the temperature locally increases.

This heat is dissipated to supporting component 20 through reflective component 4b. However, there are instances where a temperature of wavelength conversion element 4a unintentionally increases due to, for example, an increase in crystal defects as a result of consecutive emission of light having a high energy density to wavelength conversion element 4a.

In this case, as illustrated in (b) in FIG. 6, there are instances where the temperature of a binder or phosphor particles included in wavelength conversion element 4a rapidly increases, and ablation or the like occurs locally in wavelength conversion element 4a due to the increase in the temperature of the binder or the phosphor particles, leading to an affected zone being generated in wavelength conversion element 4a.

In such a case, a peak of the light intensity of first radiation light 91b increases as indicated in the comparison between (a) in FIG. 7 and (b) in FIG. 7, and the light intensity of second radiation light 92 decreases as indicated in the comparison between (a) in FIG. 8 and (b) in FIG. 8.

When the operation is continued in the state illustrated in (b) in FIG. 6 and emission light 11 is continued to be emitted to wavelength conversion component 4, illuminated region 4d to which emission light 11 is emitted in wavelength conversion element 4a is completely blown off, and emission light 11 is directly emitted to reflective component 4b as illustrated in (c) in FIG. 6.

In this case, the peak of the light intensity of first radiation light 91b extremely increases as illustrated in (c) in FIG. 7, and the light intensity of second radiation light 92 extremely decreases as illustrated in (c) in FIG. 8. In such a state as described above, radiation light which is high in monochromaticity, directivity, and an energy density as with emission light 11 is emitted from light source device 101, causing a dangerous state.

In order to avoid such a state as described above, according to the present embodiment, photodetector 7 preferentially detects the light intensity of second radiation light 92 to stop driving of semiconductor light emitting device 1. The following describes the details.

As illustrated in FIG. 4, output of signal 180 corresponding to the light intensity of second radiation light 92 detected by photodetector 7 monotonically decreases over time due to aging deterioration of light source device 101. For example, the light intensity of second radiation light 92 gradually decreases due to aging deterioration of wavelength conversion component 4.

At this time, when wavelength conversion component 4 is damaged in a period shorter than a guarantee period of light source device 101, e.g., when wavelength conversion component 4 is damaged at time TF1 indicated in FIG. 4, the decrease rate of signal 180 rapidly accelerates from time TF1 onward. In other words, the gradient of a straight line or a curved line of signal 180 becomes greater. As a result, signal 180 falls below threshold signal 190 at time TF2.

Microcontroller 141 compares signal 180 at this point of time and threshold signal 190, and a signal is transmitted to step-down circuit 142 by time TF3 immediately after time TF2, thereby causing driving current I_{OP}(t) to be zero to stop driving of semiconductor light emitting device 1. In this manner, semiconductor light emitting device 1 stops emitting emission light 11, and thus it is possible to avoid the dangerous state in which radiation light which is high in monochromaticity, directivity, and an energy density as with first radiation light 91 is emitted from light source device 101.

### (Advantageous Effects)

As described above, in light source device 101 according to the present embodiment, photodetector 7 is disposed at a location off a light path of light which is emitted from wavelength conversion component 4 and used as illumination light 110 (usable radiation light).

With this configuration, it is possible to accurately detect abnormal deterioration of wavelength conversion component 4 by photodetector 7. Accordingly, it is possible to inhibit radiation light which is high in monochromaticity, directivity, and an energy density as with emission light 11 emitted from semiconductor light emitting device 1 from being directly emitted to the outside of light source device 101. This allows implementing light source device 101 with high safety.

Moreover, even when such photodetector 7 is used, since photodetector 7 is disposed at a location off a light path of usable radiation light, it is possible to inhibit occurrence of uneveness in light intensity in the illuminated region of illumination light 110, due to photodetector 7.

Furthermore, since it is possible to implement light source device 101 which is small in size, a projection device which includes light source device 101 can be small in size as well.

In addition, according to the present embodiment, light which travels in a direction away from a direction of travel of usable radiation light is incident on photodetector 7. More specifically, light which is emitted from wavelength conversion component 4 and not used as illumination light (unnecessary light) is incident on photodetector 7.

In this manner, it is possible to detect abnormal deterioration of wavelength conversion component 4 without causing a decrease in utilization efficiency of illumination light emitted from light source device 101.

In this case, according to the present embodiment, reflective component 23 which is the first reflective component, and which reflects a portion of light that is emitted from wavelength conversion component 4 and not used as illumination light (unnecessary light) in a direction away from a direction of travel of usable radiation light is included, and light reflected by reflective component 23 is incident on photodetector 7.

With this configuration, it is possible to easily cause unnecessary light to be incident on photodetector 7.

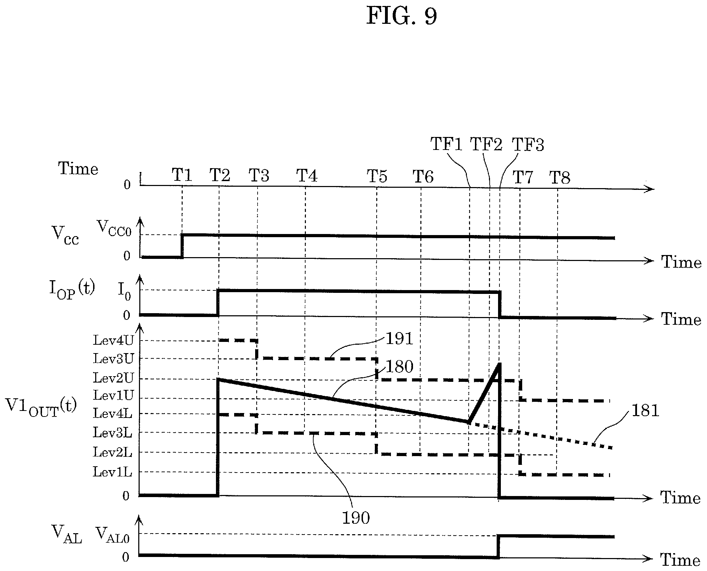

It should be noted that, although second radiation light 92 (yellow light) is used in the control method of detecting abnormal deterioration of wavelength conversion component 4 according to the above-described embodiment as illustrated in FIG. 4, the present disclosure is not limited to this example. For example, first radiation light 91 (blue light) may be used in detecting abnormal deterioration of wavelength conversion component 4. FIG. 9 is a timing chart of each of the signals of controller 140 in detecting abnormal deterioration of wavelength conversion component 4 using first radiation light 91 (blue light).

When first radiation light 91 (blue light) is used, unlike the case in which second radiation light 92 (yellow light) is used, output of first radiation light 91b (unnecessary light) by photodetector 7 increases upon occurrence of abnormal deterioration of wavelength conversion component 4 as illustrated in FIG. 7. In other words, unnecessary light which is a portion of laser light emitted from semiconductor light emitting device 1 and reflected by wavelength conversion component 4 is incident on photodetector 7. At this time, microcontroller 141 is capable of detecting abnormal deterioration of wavelength conversion component 4 based on a signal from photodetector 7. More specifically, as illustrated in FIG. 9, threshold signal 191 having a value greater than signal 180 is prepared in advance, and threshold signal 191 and signal 180 is compared. When signal 180 is greater than threshold signal 191 (time TF2 in FIG. 4), microcontroller 141 determines that abnormal deterioration has occurred in wavelength conversion component 4, and causes current I_{OP}(t) to be zero by controlling step-down circuit 142 to stop the operation of semiconductor light emitting device 1.

In this manner, it is possible to easily detect abnormal deterioration of wavelength conversion component 4, by receiving first radiation light 91b by photodetector 7. In particular, when first radiation light 91b increases, radiation light which is high in directivity and an energy density increases, and thus light source device 101 is in a state in which the safety is decreased. It is possible to accurately determine the state of light source device 101, by directly detecting first radiation light 91b which is high in the energy density as described above.

In addition, according to the present embodiment, first radiation light 91b is light other than usable radiation light. It is thus possible to accurately determine the state of light source device 101 without causing a decrease in the brightness of illumination light.

It should be noted that, it is possible to receive only first radiation light 91 by photodetector 7, by appropriately disposing a cut filter for cutting a wavelength of second radiation light 92 in front of photodetector 7, or using a filter which mainly reflects first radiation light 91 as reflective component 23.

### (Variation of Embodiment 1)

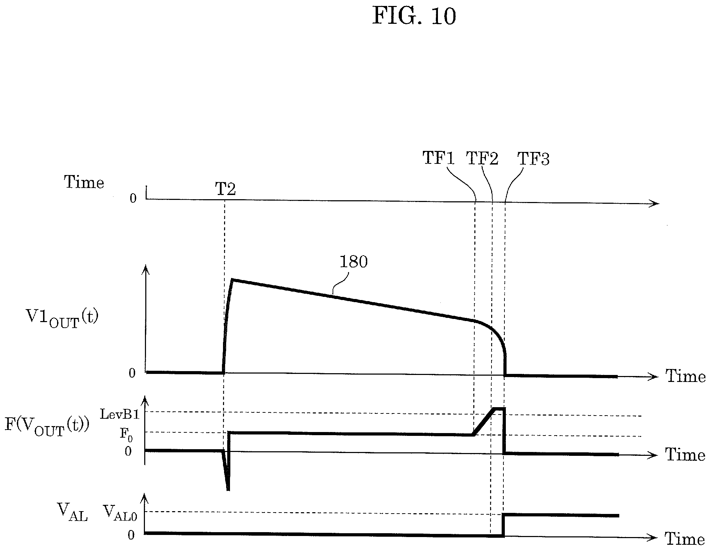

The following describes a variation example of Embodiment 1 with reference to FIG. 10. FIG. 10 is a timing chart of each of the signals of a controller included in a light source device according to the variation example of Embodiment 1.

According to the present variation, as with the above-described Embodiment 1, controller 140 performs arithmetic processing on voltage signal V1_{OUT}(t) output from photodetector 7, thereby determining abnormal deterioration of wavelength conversion component 4.

As indicated by signal 180 illustrated in FIG. 10, voltage signal V1_{OUT}(t) decreases over time according to a decrease in luminous flux of radiation light 90 of light source device 101 due to aging deterioration, under the conditions that an operation current is constant, in the present variation as well. According to the present variation, however, whether or not wavelength conversion component 4 is abnormally deteriorated is determined by calculating a rate of change of voltage signal V1_{OUT}(t), utilizing the fact that the decrease in luminous flux of radiation light 90 of light source device 101 changes at a certain rate.

For example, when the luminous flux of radiation light 90 of light source device 101 deteriorates in an exponential manner with respect to time t, luminous flux P(t) can be expressed by P(t) = P₀ × exp(-β × t). Here, P₀ is an initial luminous flux, β is a rate of deterioration, and t is time.

At this time, voltage signal V1_{OUT}(t) output from photodetector 7 can be expressed by an approximate expression of V1_{OUT}(t) = A × P₀ × exp(-β × t), using coefficient A. Here, when operation signal F(V1_{OUT}(t)) is set to F(V1_{OUT}(t)) = -B × d/dt[In(V1_{OUT}(t)/A/P₀)] using coefficient B, operation signal F(V1_{OUT}(t)) can be expressed as F(V1_{OUT}(t)) = B × β. In this manner, it is possible to determine presence or absence of abnormal deterioration of wavelength conversion component 4, based on the rate of change B × β that is a constant.

Alternatively, when the luminous flux of radiation light 90 of light source device 101 deteriorates proportional to time t, voltage signal V1_{OUT}(t) output from photodetector 7 can be expressed as a straight line, and can be expressed by an approximate expression that is V1_{OUT}(t) = V1_{OUT}(ini) - F₀ × t (V1_{OUT}(ini) is a constant). In this case, by setting operation signal F(V1_{OUT}(t)) to F(V1_{OUT}(t)) = -d/dt[V1_{OUT}(t)], it is possible to determine presence or absence of abnormal deterioration of wavelength conversion component 4, based on the rate of change Fo that is a constant.

In this manner, it is possible to accurately detect abnormal deterioration of wavelength conversion component 4 of light source device 101, using photodetector 7.

It should be noted that the above-described expressions and the like may be used in the above-described Embodiment 1. In other words, the above-described expressions and the like may be used in each of the signals in FIG. 4.

As described above, with a method of detecting an abnormality of the light source device according to the present variation as well, abnormal deterioration of wavelength conversion component 4 is detected according to signal 180 based on output of photodetector 7, in consideration of aging deterioration of wavelength conversion component 4. However, in the present variation, controller 140 determines abnormal deterioration of wavelength conversion component 4 according to variation in the rate of change based on output of photodetector 7. In this manner, it is possible to efficiently detect abnormal deterioration of wavelength conversion component 4.

### (Embodiment 2)

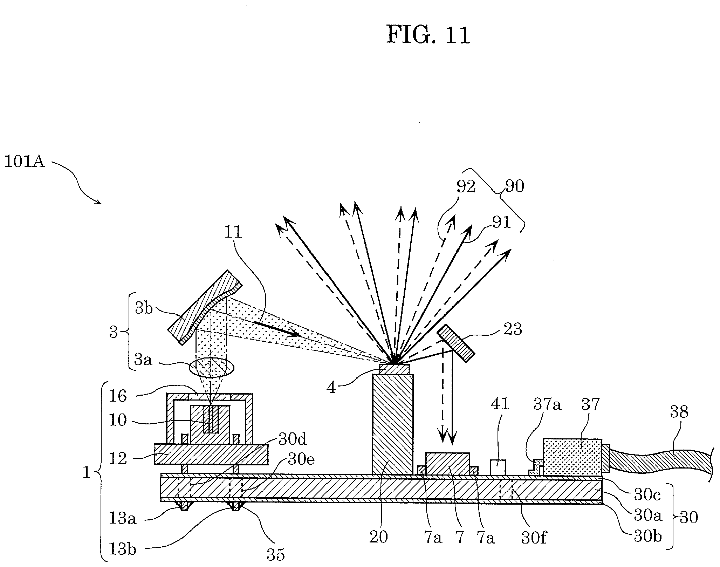

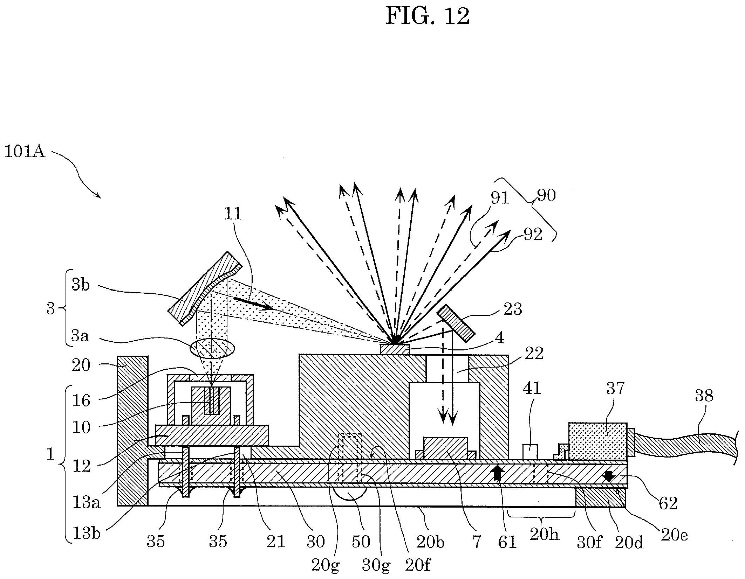

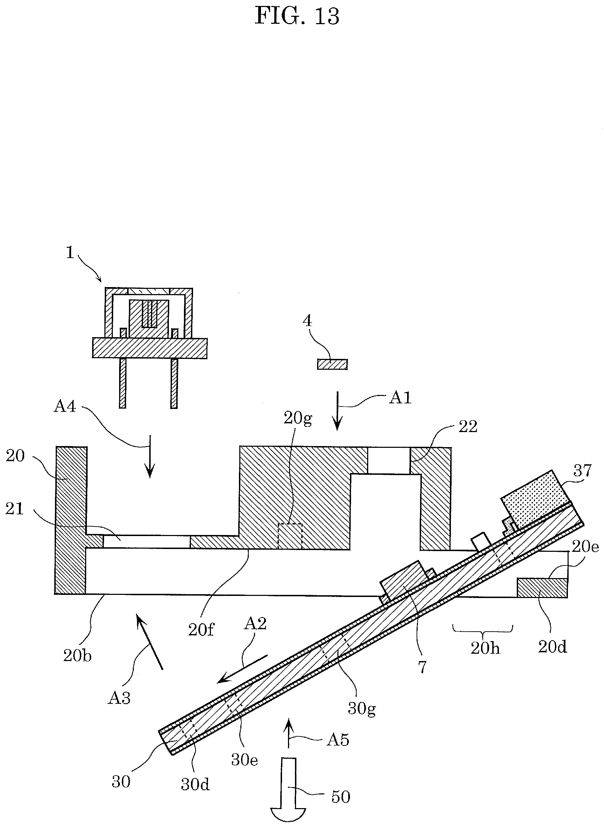

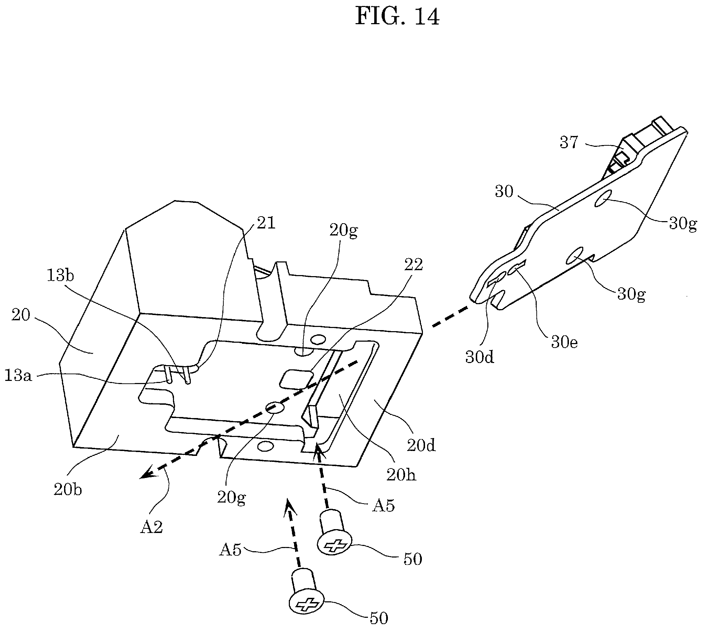

The following describes light source device 101A according to Embodiment 2, with reference to FIG.11 to FIG. 14. FIG. 11 is a schematic cross-sectional diagram which illustrates a configuration of light source device 101A according to Embodiment 2. FIG. 12 is a cross-sectional diagram which illustrates the configuration of light source device 101A according to Embodiment 2 in more detail. FIG. 13 and FIG. 14 are each diagrams for explaining a method of manufacturing light source device 101A according to Embodiment 2.

### (Configuration)

As illustrated in FIG. 11, in light source device 101A according to the present embodiment, semiconductor light emitting device 1 and photodetector 7 are disposed on first wiring board 30 attached to supporting component 20. More specifically, semiconductor light emitting device 1 and photodetector 7 are mounted on the same face of first wiring board 30. According to the present embodiment, external connecting member 37 to which external line 38 is connected, and resistive element 41 are also mounted on the face of first wiring board 30 on which semiconductor light emitting device 1 and photodetector 7 are mounted.

First wiring board 30 is a circuit board such as a printed wiring board. First wiring board 30 includes, for example, board 30a containing a glass epoxy resin, and wiring layer 30b and wiring layer 30c each including an insulating layer and a metal pattern and disposed respectively on the sides of board 30a. A metal line such as a copper foil, for example, is formed on wiring layers 30b and 30c.

Through holes 30d and 30e are provided to first wiring board 30. Lead pins 13a and 13b of semiconductor light emitting device 1 are inserted into through holes 30d and 30e, and connected to wiring layer 30b by solder 35. In addition, via wiring 30f is included in first wiring board 30. Wiring layer 30b and wiring layer 30c are electrically connected by via wiring 30f.

Terminals 7a are provided to photodetector 7. Photodetector 7 is connected to wiring layer 30c at terminals 7a.

Terminal 37a is provided to external connecting member 37. External connecting member 37 is connected to wiring layer 30c at terminal 37a.

Condenser lens 3, wavelength conversion component 4, and reflective component 23 are provided to first wiring board 30 on the side on which semiconductor light emitting device 1 is disposed. According to the present embodiment, condenser lens 3 includes first optical element 3a and second optical element 3b. First optical element 3a is a convex lens, for example. Second optical element 3b is an optical element having a reflection function, and includes, for example, a reflective component having a concave reflective surface. More specifically, when reflective component 23 is the first reflective component, second optical element 3b is the second reflective component which reflects emission light 11 emitted from semiconductor light emitting device 1. Emission light 11 emitted from semiconductor light emitting device 1 is condensed onto wavelength conversion component 4 by first optical element 3a and second optical element 3b.

Wavelength conversion component 4 emits radiation light 90 including usable radiation light that is used as illumination light, from a face on which emission light 11 reflected by condenser lens 3 (second optical element 3b) is incident. Wavelength conversion component 4 is supported by supporting component 20. Although not illustrated in the diagram, condenser lens 3 and reflective component 23 may be fixed to supporting component 20, or may be held by a holding component which is not illustrated in the diagram.

The following describes a further preferable configuration of light source device 101A according to Embodiment 2, with reference to FIG. 12 to FIG. 14.

In light source device 101A illustrated in FIG. 12 to FIG. 14, first wiring board 30 is fixed to supporting component 20 including an aluminum alloy, for example.

Supporting component 20 has heat dissipation surface 20b for dissipating heat generated in light source device 101A to the outside, on one of surfaces of supporting component 20. Supporting component 20 has mounting face 20f which is for fixing first wiring board 30, and is positioned one level inward from heat dissipation surface 20b. In addition, supporting component 20 includes holding portion 20d for stably fixing first wiring board 30. Holding portion 20d includes mounting face 20e on a side opposite to mounting face 20f. Opening portion 20h for disposing first wiring board 30 at a predetermined position when manufacturing light source device 101A is provided between mounting face 20f and mounting face 20e. Threaded hole 20g for fixing first wiring board 30 is formed in mounting face 20f of supporting component 20 (see FIG. 14).

In addition, supporting component 20 is provided with first opening portion 21 for electrically connecting semiconductor light emitting device 1 to first wiring board 30, and second opening portion 22 for guiding a portion of light emitted from wavelength conversion component 4 to photodetector 7. In other words, light that is incident on photodetector 7 passes through second opening portion 22. With this configuration, it is possible to guide the light emitted from wavelength conversion component 4 to photodetector 7 via second opening portion 22. Specifically, the light reflected by reflective component 23 passes through second opening portion 22.

In addition, supporting component 20 is provided with a recess (recessed portion) which is continuous with second opening portion 22, and photodetector 7 is disposed in the recess. With this configuration, it is possible to selectively cause light to be incident on photodetector 7 as well as possible to protect photodetector 7. More specifically, it is possible to cause only the light (unnecessary light) which is a portion of radiation light 90 emitted from wavelength conversion component 4, and is not used in projection component to be easily incident on photodetector 7.

Semiconductor light emitting device 1, wavelength conversion component 4, and first wiring board 30 are fixed to supporting component 20. Semiconductor light emitting device 1 and photodetector 7 are connected to first wiring board 30. Semiconductor light emitting device 1 and photodetector 7 are disposed on first wiring board 30 on the side of supporting component 20.

### (Manufacturing Method)

The following describes a method of manufacturing light source device 101A according to the present embodiment illustrated in FIG. 12, with reference to FIG. 13 and FIG. 14. In FIG. 13 and FIG. 14, A1 to A5 indicate an order of assembling, and light source device 101A is assembled according to the procedure from A1, trough A2, A3, A4, to A5.

First, as indicated by A1 in FIG. 13, wavelength conversion component 4 is fixed to a predetermined position of supporting component 20.

Next, as indicated by A2 and A3 in FIG. 13, a portion of first wiring board 30 on which photodetector 7 and external connecting member 37 are mounted is diagonally inserted to opening portion 20h of supporting component 20, and first wiring board 30 is mounted on supporting component 20 such that a surface of first wiring board 30 closely adheres to mounting face 20f.

Next, as indicated by A4 in FIG. 13, semiconductor light emitting device 1 is placed above first opening portion 21 of supporting component 20, and lead pins 13a and 13b of semiconductor light emitting device 1 are inserted to first opening portion 21 of supporting component 20 as well as to through holes 30d and 30e of first wiring board 30.

Next, as indicated by A5 in FIG. 13 and FIG. 14, first wiring board 30 inserted through opening portion 20h of supporting component 20 is mounted such that first wiring board 30 is in contact with mounting face 20e that is the upper surface of holding portion 20d of supporting component 20 and mounting face 20f that is the bottom surface of supporting component 20, and is positioned one level inward from heat dissipation surface 20b, and screws 50 are screwed into screw hole 30g of first wiring board 30 and screw hole 20g of supporting component 20. In this manner, it is possible to fix first wiring board 30 to supporting component 20.

Next, as illustrated in FIG. 12, lead pins 13a and 13b of semiconductor light emitting device 1 are connected to first wiring board 30, using solder 35. Then, condenser lens 3 and reflective component 23 are fixed to supporting component 20, using a holding component which is not illustrated in the diagrams.

### (Operation)

The following describes an operation of light source device 101A according to Embodiment 2.

Power provided from external connecting member 37 is transmitted through wiring layer 30b, via wiring 30f, and wiring layer 30c of first wiring board 30, to semiconductor light emitting element 10 of semiconductor light emitting device 1. In this manner, light is emitted from semiconductor light emitting element 10. The light emitted from semiconductor light emitting element 10 is emitted as emission light 11 of semiconductor light emitting device 1. Emission light 11 emitted from semiconductor light emitting device 1 is condensed by condenser lens 3 and incident on wavelength conversion component 4. In this manner, radiation light 90 is emitted from wavelength conversion component 4. Radiation light 90 includes first radiation light 91 and second radiation light 92. Emission light 11 which is not wavelength-converted by wavelength conversion component 4 is emitted from wavelength conversion component 4 as first radiation light 91. Emission light 11 which is wavelength-converted by wavelength conversion component 4 is emitted from wavelength conversion component 4 as second radiation light 92.

At this time, a portion of the light (unnecessary light) which is a portion of radiation light 90 emitted from wavelength conversion component 4, and is not used in the projection component (not illustrated) is received by photodetector 7 disposed at a location off the light path of a portion of radiation light 90 (usable radiation light) which is emitted from wavelength conversion component 4 and used in the projection component (not illustrated) as illumination light.

More specifically, a portion of radiation light 90 which is not used in the projection component (unnecessary light) is reflected by reflective component 23 toward first wiring board 30, guided through second opening portion 22 of supporting component 20 to photodetector 7 connected to first wiring board 30, and received by photodetector 7.

The light received by photodetector 7 is converted to an electrical signal by photodetector 7. At this time, in the circuit illustrated in FIG. 2, the electrical signal becomes a voltage signal proportional to an amount of light received, and the voltage signal is output from external connecting member 37 to controller 140. Controller 140 determines, based on the voltage signal, an abnormal state of wavelength conversion component 4, and turns on or off semiconductor light emitting device 1 according to the result of determining, thereby making it possible to inhibit radiation light which is high in monochromaticity, directivity, and an energy density as with emission light 11 emitted from semiconductor light emitting device 1 from being emitted to the outside of light source device 101A.

### (Advantageous Effects)

As described above, with light source device 101A according to the present embodiment, as with Embodiment 1, photodetector 7 is disposed at a location off a light path of usable radiation light which is light emitted from wavelength conversion component 4 to a space, and used as illumination light 110.

With this configuration, it is possible to accurately detect abnormal deterioration of wavelength conversion component 4 by photodetector 7 to implement light source device 101A with high safety, as well as possible, even when photodetector 7 is used, to inhibit uneveness in light intensity from occurring in an illuminated region of illumination light 110 due to photodetector 7. Furthermore, since it is possible to implement light source device 101A which is small in size, a projection device which includes light source device 101A can be small in size as well.

In addition, according to the present embodiment, the circuit board to which semiconductor light emitting device 1 and photodetector 7 are attached is a single circuit board. More specifically, semiconductor light emitting device 1 and photodetector 7 are both attached to first wiring board 30.

With this configuration, it is possible to implement further miniaturized light source device 101A.

In particular, according to the present embodiment, not only semiconductor light emitting device 1 and photodetector 7 but also the components such as external connecting member 37 and resistive element 41 which require electrical wiring are connected to the same first wiring board 30.

With this configuration, it is possible to reduce wiring defects such as line disconnection, even when light source device 101A is mounted on a vehicle or the like which is subject to strong vibration or impact, as well as possible to simplify the configuration of electrical wiring of light source device 101A. In addition, since semiconductor light emitting device 1 and photodetector 7 are mounted on the same face side of first wiring board 30, it is possible to easily manufacture light source device 101A.

In addition, since the components such as semiconductor light emitting device 1, photodetector 7, external connecting member 37, and resistive element 41 which require electrical wiring are connected to the same first wiring board 30, it is possible to implement a light source device which is free from wiring defects and highly reliable.

More specifically, with conventional light emitting device 1001 illustrated in FIG. 41, photodetector 1011 and semiconductor laser element 1002 are spaced away from each other, and thus electrical wiring for connecting photodetector 1011, controller 1009, driving circuit 1010, and semiconductor laser element 1002 to one another is made complicated or elongated. For example, there is a possibility that the wiring pattern of the circuit board is complicated or elongated, or the electrical wiring is disconnected or short-circuited because the components need to be mutually connected by a lead. As a result, there is a possibility that light conversion abnormality of phosphor 1004 cannot be detected.

In contrast, with light source device 101A according to the present embodiment, components such as semiconductor light emitting device 1 and photodetector 7 which require electrical wiring are arranged on the same first wiring board 30. With this configuration, it is possible to inhibit electrical wiring (connection wiring) which connects semiconductor light emitting device 1, photodetector 7, etc. from being complicated or elongated. This allows inhibiting the wiring defects from occurring due to breakage or short-circuit of electrical wiring. Accordingly, it is possible to implement a light source device which is highly reliable. In addition, since the electrical wiring is simplified, it is possible to implement light source device 101A which is small in size.

In addition, according to the present embodiment, second optical element 3b which reflects emission light 11 that is emitted from semiconductor light emitting device 1 and travels in a direction away from first wiring board 30 is included, and wavelength conversion component 4 emits usable radiation light from the face on which emission light 11 reflected by second optical element 3b is incident.

With this configuration, it is possible to implement a reflecting light path through which emission light 11 emitted from semiconductor light emitting device 1 travels and emitted as radiation light 90 from light source device 101A, by the optical system. It is thus possible to decrease the thickness of the light source device; that is, the length of the light source device in the up and down direction in FIG. 12.

In addition, according to the present embodiment, first wiring board 30 is mounted on mounting face 20f different from heat dissipation surface 20b of supporting component 20.

With this configuration, it is possible to inhibit the heat dissipation performance for dissipating heat generated in light source device 101A from decreasing due to the presence of first wiring board 30.

In addition, according to the present embodiment, first wiring board 30 is fixed to supporting component 20 in the state in which first wiring board 30 is sandwiched between mounting face 20f and mounting face 20e.

With this configuration, first wiring board 30 is held by supporting component 20 in a stable manner.

In particular, according to the present embodiment, holding portion 20d including mounting face 20e is disposed in proximity to external connecting member 37, specifically, under external connecting member 37.

With this configuration, it is possible to inhibit first wiring board 30 from being deformed as a result of being bent or broken, even in the case where stress is applied to external connecting member 37 when external line 38 is pulled out from or inserted into external connecting member 37 (connector). In particular, when first wiring board 30 is a resin board, stress is likely to be applied intensely to first wiring board 30 in proximity to external connecting member 37 when external line 38 is pulled out from or inserted into external connecting member 37. In view of this, holding portion 20d is provided to supporting component 20, thereby making it possible to effectively inhibit deformation of first wiring board 30. In addition, at this time, first wiring board 30 may be fixed to supporting component 20 in proximity to opening portion 20h, such that, for example, force 61 and force 62 are applied in the direction toward mounting face 20f and in the direction toward mounting face 20e.

In addition, according to the present embodiment, lead pins 13a and 13b which are inserted from the surface of first wiring board 30 (the face on which external connecting member 37 is mounted) through first opening portion 21 of supporting component 20 are soldered by solder 35 on a rear face of first wiring board 30 (a face opposite to the face on which external connecting member 37 is mounted).

In this manner, it is possible to firmly fix first wiring board 30 to supporting component 20, using solder 35 and holding portion 20d.

In addition, first wiring board 30 is fixed to mounting face 20f of supporting component 20, using screw 50.

With this configuration, it is possible to stably fix first wiring board 30 to supporting component 20.

### (Lamp)

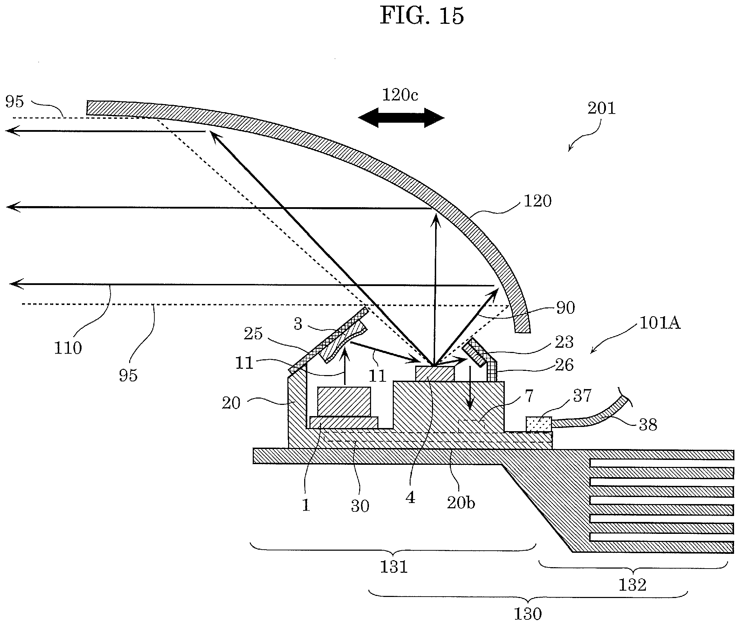

The following describes lamp 201 on which light source device 101A according to the present embodiment is mounted, with reference to FIG. 15. FIG. 15 is schematic cross-sectional diagram which illustrates a configuration of lamp 201 on which light source device 101A according to Embodiment 2 is mounted.

As illustrated in FIG. 15, lamp 201 is one example of the projection device, and includes: heat dissipation component 130; light source device 101A attached to heat dissipation component 130; and projection component 120 which projects light emitted from light source device 101A to the outside.

In light source device 101A, emission light 11 emitted from semiconductor light emitting device 1 is condensed onto wavelength conversion component 4 by condenser lens 3. Condenser lens 3 is held by holding component 25 fixed to supporting component 20. Holding component 25 has a function of holding condenser lens 3, and also has a function of adjusting a position of condenser lens 3. In addition, reflective component 23 is held by holding component 26 fixed to supporting component 20.

A portion of radiation light 90 emitted from wavelength conversion component 4 is reflected by reflective component 23 and incident on photodetector 7.

As heat dissipation component 130, for example, a heat dissipation component obtained by processing an aluminum alloy into a predetermined shape, and alumiting the surface of the aluminum alloy can be used. Heat dissipation component 130 includes mounting portion 131 which has a plate shape and is for mounting light source device 101A thereon, and cooling fin 132 for exhausting heat generated in light source device 101A into the external air. The heat generated in light source device 101A is transmitted to cooling fin 132 via mounting portion 131, and dissipated to the outside.

Projection component 120 is disposed on the side to which radiation light 90 is emitted from light source device 101A, and reflects radiation light 90 emitted from light source device 101A toward the front side. According to the present embodiment, projection component 120 is, for example, a reflector (reflector plate) including a plastic member having a recessed face, and an aluminum film formed on a surface of the recessed face.

In lamp 201, radiation light 90 emitted in a Lambertian light distribution from light source device 101A toward projection component 120 is reflected by projection component 120 so as to be substantially parallel light, and projected to the outside of lamp 201 as illumination light 110.

At this time, only a portion of radiation light which is radiation light 90 emitted from projection component 120 and is restricted by usable radiation range 95 due to opening restriction is emitted from lamp 201 as illumination light 110.

Illumination light 110 emitted from lamp having the above-described configuration is light which is high in directivity. However, a large portion of illumination light 110 is fluorescence having a broad spectrum, and projection component 120 with a large pupil diameter converts illumination light 110 into substantially parallel light which is low in energy density per unit area. Thus, the dangerousness of illumination light 110 is sufficiently low compared with emission light 11.

Meanwhile, a portion of radiation light which is radiation light 90 and is emitted to the outside of usable radiation range 95 is reflected by reflective component 23, and received by photodetector 7 mounted on first wiring board 30. In this manner, it is possible to detect abnormal deterioration of wavelength conversion component 4.

As described above, it is possible to receive light from wavelength conversion component 4 by photodetector 7, using radiation light emitted to the outside of usable radiation range 95. Accordingly, it is possible to detect abnormal deterioration of wavelength conversion component 4 from a decrease in luminous flux of illumination light 110, and also possible, even when photodetector 7 is used, to inhibit uneveness in light intensity from occurring in illuminated region of illumination light due to photodetector 7.

In this manner, with lamp 201 including light source device 101A, when wavelength conversion component 4 is damaged during operation of light source device 101A, a change in the light intensity of radiation light 90 is detected by photodetector 7 to transmit a signal to controller 140 using external line 38, thereby making it possible to stop the operation of semiconductor light emitting device 1.

In addition, in lamp 201 according to the present embodiment, external connecting member 37 and external line 38 of light source device 101A are disposed on a side of light source device 101A which is opposite to a side of light source device 101A to which illumination light 110 to be emitted to the outside travels in which illumination light 110 is. With this configuration, it is possible to simplify electric wiring of lamp 201.

In addition, since light source device 101A which has the above-described configuration is small in size, it is possible to implement a lamp which is small in size, by using light source device 101A as a light source of lamp 201.

In addition, light source device 101A which has the above-described configuration includes in advance wavelength conversion component 4, reflective component 23, and photodetector 7, and a position of projection component 120 with respect to light source device 101A is adjusted in the directions of adjustment axis 120c. In the process of adjustment, a positional relationship between wavelength conversion component 4, reflective component 23, and photodetector 7 does not change, and thus it is possible to accurately detect an emission state of wavelength conversion component 4.

In addition, condenser lens 3 (reflective component) of light source device 101A is disposed closer to semiconductor light emitting device 1 than projection component 120, and fixed to supporting component 20 which is the same supporting component to which semiconductor light emitting device 1 and wavelength conversion component 4 are fixed. The light path of illumination light 110 emitted from wavelength conversion component 4 and reflected by projection component 120 to be emitted to the outside does not intersect with the light path of emission light 11 emitted from semiconductor light emitting device 1 to reach wavelength conversion component 4. Accordingly, for example, when the position of projection component 120 is adjusted while light source device 101A is caused to emit light, it is possible to easily adjust the light path of light which is incident on projection component 120 and the light path of light emitted from projection component 120 in the state in which the light paths in light source device 101A are fixed.

In addition, lamp 201 is mounted on heat dissipation surface 20b which is a face of supporting component 20 opposite to a face on which projection component 120 is disposed.

With this configuration, it is possible to easily transmit heat generated in light source device 101A to heat dissipation component 130, without restricting the light path of usable radiation light emitted from wavelength conversion component 4.

First wiring board 30 of light source device 101A is mounted on mounting face 20f which is a face of supporting component 20 opposite to the face on which projection component 120 is disposed and different from heat dissipation surface 20b.

With this configuration, when transmitting heat generated in wavelength light source device 101A to heat dissipation component 130, it is possible to inhibit the heat dissipation performance for dissipating heat generated in light source device 101A from decreasing due to the presence of first wiring board 30.

In addition, cooling fin 132 is disposed on a side of heat dissipation component 130 which is opposite to a side of heat dissipation component 130 to which illumination light 110 to be emitted to the outside travels.

With this configuration, it is possible to easily dissipate heat generated in light source device 101A to the outside (e.g., to the atmosphere), without restricting the light paths of usable radiation light in lamp 201.

In addition, emission light 11 that is laser light emitted from semiconductor light emitting device 1 is reflected by condenser lens 3 (reflective component) which is disposed closer to semiconductor light emitting device 1 than projection component 120, and emitted onto wavelength conversion component 4. Emission light 11 reflected by condenser lens 3 travels in the direction opposite to the direction in which illumination light 110 is emitted to the outside.

With this configuration, even when wavelength conversion component 4 is damaged during operation of light source device 101A, radiation light which is high in directivity and an energy density is emitted always to a portion of a component included in lamp 201, and thus it is possible to inhibit the radiation light from being directly emitted to the outside of lamp 201. In other words, it is possible to reduce an energy density of radiation light which is high in directivity and the energy density. Accordingly, it is possible to enhance safety of lamp 201.

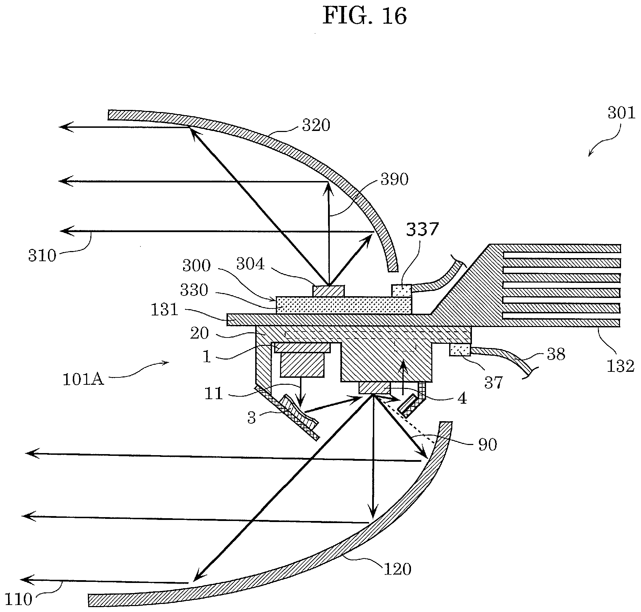

It should be noted that the projection device including light source device 101A may be configured as lamp 301 illustrated in FIG. 16.

As illustrated in FIG. 16, lamp 301 includes heat dissipation component 130, light source device 101A (first light source device) mounted on one face of mounting portion 131 of heat dissipation component 130, light source device 300 (second light source device) mounted on the other face of mounting portion 131, projection component 120, and projection component 320.

Light source device 300 includes wiring board 330, semiconductor light emitting device 304 disposed on wiring board 330, and external connecting member 337 for supplying power to wiring board 330 from outside. Semiconductor light emitting device 304 includes, for example, a white LED element which emits white light and mounted in a package.

Projection component 120 is a first reflector which reflects radiation light 90 emitted from light source device 101A toward the front side. Projection component 320 is a second reflector which reflects, toward the front side, radiation light 390 emitted from light source device 300 as illumination light 310 that is substantially parallel.

With this configuration, it is possible to implement a lamp which is small in size, and on which two types of light source devices are mounted. It should be noted that lamp 301 is, for example, a vehicular headlight in which light source device 101A can be used as a high beam and light source device 300 can be used as a low beam.

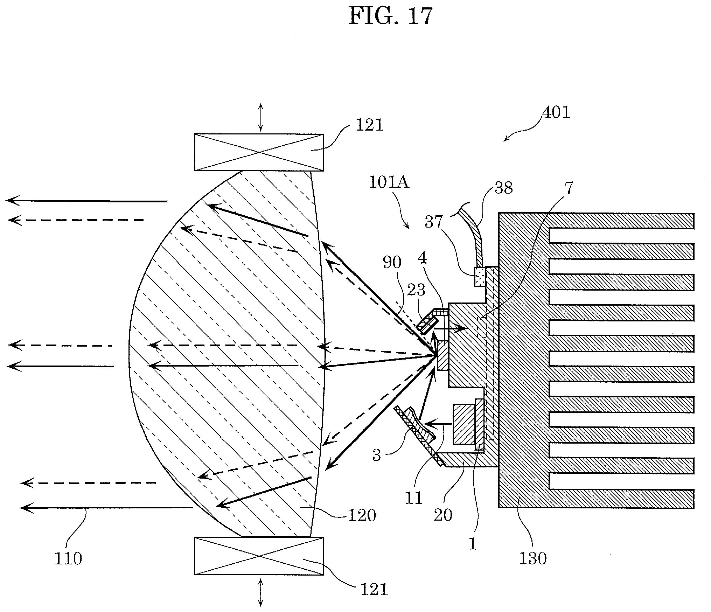

In addition, the projection device including light source device 101A may be configured as lamp 401 illustrated in FIG. 17.

As illustrated in FIG. 17, lamp 301 includes: heat dissipation component 130; light source device 101A attached to heat dissipation component 130; projection component 120 disposed in front of light source device 101A; and actuator 121 mounted on projection component 120.

Projection component 120 is a projection lens. More specifically, projection component 120 is, for example, a collimate lens which converts radiation light 90 to illumination light 110 which is parallel light. Actuator 121 is a motor or the like which causes projection component 120 to horizontally move in a direction perpendicular to the direction of travel of illumination light 110.

With lamp 301 illustrated in FIG. 17, it is possible to move projection component 120 by actuator 121. With this configuration, it is possible to perform fine adjustment of an illumination area of illumination light 110. In the process of the adjustment, a positional relationship between wavelength conversion component 4, reflective component 23, and photodetector 7 of light source device 101A does not change, and thus it is always possible to accurately detect an emission state of wavelength conversion component 4.

### (Embodiment 3)

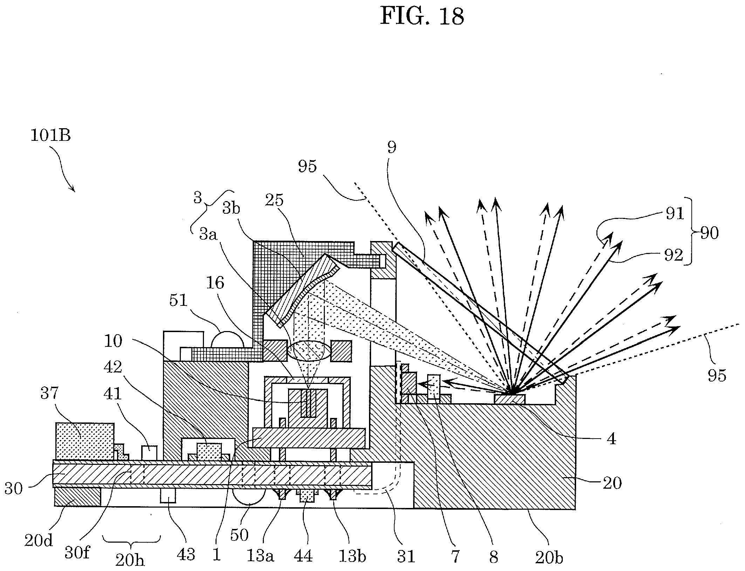

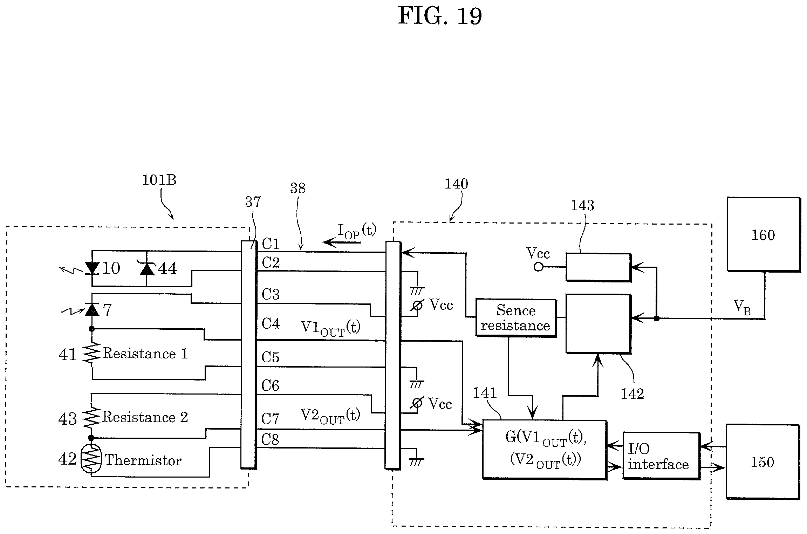

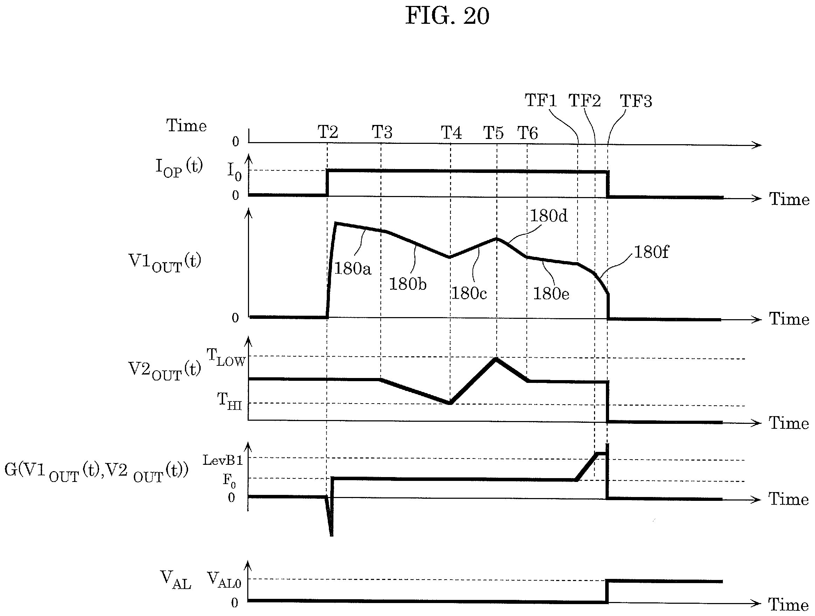

The following describes light source device 101B according to Embodiment 3, with reference to FIG. 18 to FIG. 20. FIG. 18 is a schematic cross-sectional diagram which illustrates a configuration of light source device 101B according to Embodiment 3. FIG. 19 is a circuit block diagram which illustrates a circuit configuration of light source device 101B according to Embodiment 3, and a circuit configuration of a driving unit for driving light source device 101B. FIG. 20 is a timing chart of each signal of controller 140 included in light source device 101B according to Embodiment 3.

### (Configuration)

As illustrated in FIG. 18, light source device 101B according to the present embodiment further includes temperature detection element 42 in addition to the components included in light source device 101 according to Embodiment 1.

Temperature detection element 42 detects a temperature in proximity to semiconductor light emitting device 1. More specifically, temperature detection element 42 is disposed in a recess (recessed portion) formed in supporting component 20. In addition, temperature detection element 42 is disposed at a position closer to semiconductor light emitting device 1 than to photodetector 7.

Temperature detection element 42 is, for example, a thermistor. According to the present embodiment, a negative temperature coefficient (NTC) thermistor is employed as temperature detection element 42. However, temperature detection element 42 according to the present disclosure is not limited to this example.

Temperature detection element 42 is mounted on first wiring board 30 on which semiconductor light emitting device 1 is mounted. According to the present embodiment, temperature detection element 42 is mounted on a face of first wiring board 30 on which semiconductor light emitting device 1 is mounted. More specifically, temperature detection element 42 is housed in the recess (recessed portion) formed in supporting component 20, between first wiring board 30 and supporting component 20.

In addition, light source device 101B includes resistive element 43 and protector element 44. Resistive element 43 causes resistance change of temperature detection element 42 to change into voltage change. Protector element 44 is, for example, a Zener diode. According to the present embodiment, resistive element 43 and protector element 44 are mounted on a face of first wiring board 30 which is opposite to the face on which semiconductor light emitting device 1 is mounted.

Light source device 101B further includes transparent cover component 9. Transparent cover component 9 is disposed in front of wavelength conversion component 4; that is, on the side to which radiation light 90 is emitted. Transparent cover component 9 is fixed to supporting component 20.

In addition, although photodetector 7 is disposed according to the present embodiment as with Embodiment 1 and Embodiment 2, photodetector 7 is fixed to supporting component 20 unlike Embodiment 1 and Embodiment 2. Photodetector 7 is electrically connected to first wiring board 30 via second wiring board 31. Second wiring board 31 is, for example, a flexible printed circuit.

Photodetector 7 is disposed in proximity to wavelength conversion component 4. According to the present embodiment, photodetector 7 is disposed such that a light receiving surface faces the side on which wavelength conversion component 4 is located. In addition, for example, optical filter 8 which reflects a portion or the entirety of light having a wavelength less than or equal to 500 nm is disposed between wavelength conversion component 4 and photodetector 7.

### (Operation)

The following describes an operation of light source device 101B with reference to FIG. 19 and FIG. 20.

As illustrated in FIG. 19, controller 140 supplies, using anode terminal C1 and cathode terminal C2, current I_{OP}(t) for driving semiconductor light emitting device 1 (semiconductor light emitting element 10). In addition, controller 140 receives a signal generated by photodetector 7, resistive element 41, temperature detection element 42, and resistive element 43, as well as supplies power to photodetector 7.

As illustrated in FIG. 20, according to the present embodiment, controller 140 performs arithmetic processing on voltage signal V1_{OUT}(t) output from photodetector 7 and resistive element 41, and on voltage signal V2_{OUT}(t) output from temperature detection element 42 and resistive element 43, thereby determining abnormal deterioration of wavelength conversion component 4.

As indicated by signals 180a to 180f illustrated in FIG. 20, whether or not wavelength conversion component 4 is abnormally deteriorated is determined by calculating a rate of change of voltage signal V1_{OUT}(t), utilizing the fact that the decrease in luminous flux of radiation light 90 of light source device 101B changes at a constant rate, under the conditions that an operation current is constant, in the present embodiment as well. However, according to the present embodiment, whether or not wavelength conversion component 4 is abnormally deteriorated is determined in consideration of temperature dependency of light emission of semiconductor light emitting device 1. Detailed description will be given below.

Semiconductor light emitting device 1 of light source device 101B has temperature dependency that light emission changes when an environmental temperature changes, when an energizing current is constant. For example, when the temperature decreases, light emission of semiconductor light emitting device 1 increases. In contrast, when the temperature increases, light emission of semiconductor light emitting device 1 decreases.

In view of the above, in controller 140, the temperature dependency of semiconductor light emitting device 1 is measured in advance, and the amount of change in light emission due to the temperature dependency of semiconductor light emitting device 1 is compensated by operation performed by microcontroller 141.

FIG. 20 shows that a decreasing gradient of each of signal 180b and signal 180d of voltage signal V1_{OUT}(t) increases in the periods from T3 to T4 and from T5 to T6, and an increasing gradient of signal 180c of voltage signal V1_{OUT}(t) increases in the period from T4 to T5. FIG. 20 also shows that, as indicated by voltage signal V2_{OUT}(t) output from temperature detection element 42, the light emission of photodetector 7 decreases as a result of being affected by the increase in the environmental temperature in the periods from T3 to T4 and from T5 to T6, and the light emission of photodetector 7 increases as a result of being affected by the decrease in the environmental temperature in the periods from T4 to T5. Specific examples of changes in the environment temperature include, for example, an increase in the temperature from the morning through the daytime, and a decrease in the temperature from the early afternoon through the night, etc. In view of the above, according to the present embodiment, the temperature dependency is caused to compensate for the amount of change in light emission of photodetector 7 due to the temperature dependency.

For example, the luminous flux of radiation light 90 of light source device 101B is calculated by G(V1_{OUT}(t), V2_{OUT}(t)), thereby compensating the amount of change in light emission of photodetector 7 due to the temperature dependency. Then, the rate of change F₀ relative to time t of the luminous flux of radiation light 90 of light source device 101B is calculated. Then, the presence or absence of abnormal deterioration of wavelength conversion component 4 is determined based on the rate of change F₀.

More specifically, a portion of radiation light 90 is received by photodetector 7 and, when G(V1_{OUT}(t), V2_{OUT}(t)) is greater than or equal to LevB1, wavelength conversion component 4 is determined to be abnormally deteriorated. Then, current flowing through anode terminal C1 is stopped, thereby stopping the operation of semiconductor light emitting device 1.

In addition, for example, voltage VAL that is an alert signal is set to a predetermined voltage V_{ALO}, so as to cause a warning lamp to display a warning signal, simultaneously with stopping the operation of semiconductor light emitting device 1.

As described above, with the method of detecting an abnormality of light source device 101B according to the present embodiment as well, abnormal deterioration of wavelength conversion component 4 is detected according to signal 180 based on output of photodetector 7, in consideration of aging deterioration of wavelength conversion component 4. However, in the present embodiment, controller 140 cancels the change in light emission of semiconductor light emitting device 1 due to the environmental temperature, and determines abnormal deterioration of wavelength conversion component 4 based on the variation in the rate of change based on output of photodetector 7. In this manner, since it is possible to ignore the influence of the change in light emission due to temperature dependency of semiconductor light emitting device 1, it is possible to further accurately detect abnormal deterioration of wavelength conversion component 4.

### (Advantageous Effect)

As described above, with light source device 101B according to the present embodiment, as with Embodiment 1 and Embodiment 2, photodetector 7 is disposed at a location off a light path of usable radiation light which is light emitted from wavelength conversion component 4 to a space, and used as illumination light 110.

With this configuration, it is possible to accurately detect abnormal deterioration of wavelength conversion component 4 by photodetector 7 to implement light source device 101B with high safety, as well as possible, even when photodetector 7 is used, to inhibit uneveness in light intensity from being generated in an illuminated region of illumination light 110 due to photodetector 7. Furthermore, since it is possible to implement light source device 101B which is small in size, a projection device which includes light source device 101B can also be small in size.

In addition, light source device 101B according to the present embodiment includes temperature detection element 42 disposed at a position closer to semiconductor light emitting device 1 than to photodetector 7.

With this configuration, it is possible to determine whether or not wavelength conversion component 4 is abnormally deteriorated, in consideration of temperature dependency of light emission of semiconductor light emitting device 1. Accordingly, it is possible to further accurately detect abnormal deterioration of wavelength conversion component 4.

In addition, since light source device 101B includes temperature detection element 42 and temperature detection element 42 is capable of detecting a temperature in proximity to semiconductor light emitting device 1, controller 140 is capable of causing light source device 101B to operate further safely. More specifically, when the temperature obtained from temperature detection element 42 becomes greater than or equal to a predetermined temperature, controller 140 decreases the amount of current applied to semiconductor light emitting device 1. In this manner, since it is possible to inhibit an increase in the temperature of light source device 101B, deterioration of semiconductor light emitting device 1 can be inhibited. In addition, also when the temperature of semiconductor light emitting device 1 becomes less than or equal to a constant temperature, e.g., 0 degrees Celsius or less, controller 140 decreases the amount of current applied to semiconductor light emitting device 1. In this manner, it is possible to inhibit that intensity of emission light 11 emitted from semiconductor light emitting device 1 increases due to a decrease in the temperature, emission light 11 which is high in light density is emitted onto wavelength conversion component 4, and thus wavelength conversion component 4 is damaged.

### (Variation of Embodiment 3)

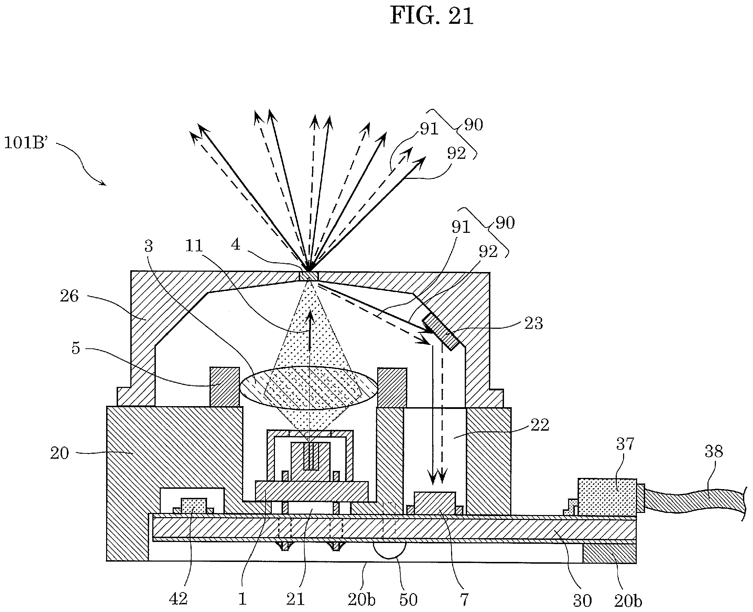

The following describes a variation example of Embodiment 3 with reference to FIG. 21. FIG. 21 is a schematic cross-sectional diagram which illustrates a configuration of light source device 101B' according to the variation example of Embodiment 3.

Light source device 101B according to Embodiment 3 described above has the configuration in which excitation light is reflected by the wavelength conversion component and emitted as irradiation light. However, light source device 101B' according to the present variation has a configuration in which excitation light is transmitted through a wavelength conversion component and emitted as irradiation light. More specifically, with light source device 101B according to Embodiment 3 described above, emission light 11 emitted from semiconductor light emitting device 1 is incident on one of the faces of wavelength conversion component 4 and radiation light 90 is emitted from the one of the faces. However, as illustrated in FIG. 21, with light source device 101B' according to the present variation, emission light 11 emitted from semiconductor light emitting device 1 is incident on one of the faces of wavelength conversion component 4 and radiation light 90 is emitted from the other face of wavelength conversion component 4. In other words, wavelength conversion component 4 emits radiation light 90 from a face opposite to a face on which emission light 11 emitted from semiconductor light emitting device 1 is incident.

According to the present variation, wavelength conversion component 4 is disposed at a position to face semiconductor light emitting device 1 across condenser lens 3. Wavelength conversion component 4 is held by holding component 26 to which reflective component 23 is fixed, and holding component 26 is fixed to supporting component 20. More specifically, wavelength conversion component 4 is fitted to a through hole of holding component 26.

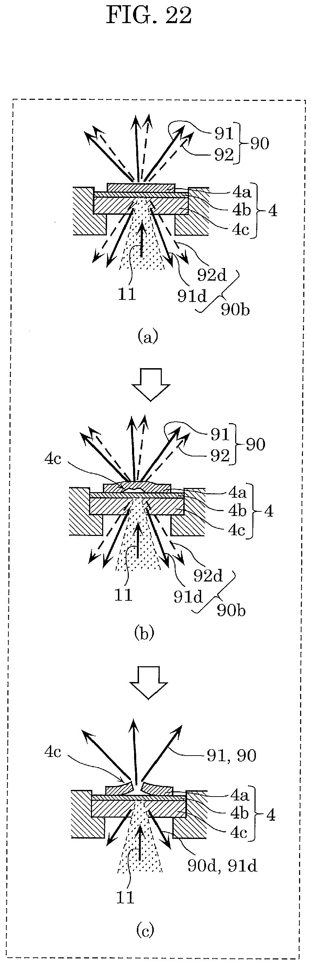

Here, a control method for accurately detecting deterioration of wavelength conversion component 4 in light source device 101B' according to the present variation will be described with reference to FIG. 22. FIG. 22 is a diagram for explaining a change in shape of wavelength conversion component 4 of light source device 101B' according to the variation example of Embodiment 3 and a change in radiation light.

Wavelength conversion component 4 includes supporting component 4c, wavelength conversion element 4a disposed above supporting component 4c, and reflective component 4b disposed between supporting component 4c and wavelength conversion element 4a, as illustrated in (a) in FIG. 22.

Wavelength conversion element 4a includes, for example, a fluorescent material of at least one type. Supporting component 4c is, for example, a transparent component including sapphire or the like. In the present variation, reflective component 4b is a dichroic mirror which transmits light having a wavelength of emission light 11, and reflects light generated in wavelength conversion element 4a and having a wavelength of florescence, and includes a dielectric multi-layer, for example.

Emission light 11 which is incident on wavelength conversion element 4a is emitted as first radiation light 91 and second radiation light 92. First radiation light 91 and second radiation light 92 are emitted to the outside from wavelength conversion element 4a through a face opposite to a face on which emission light 11 is incident.

In addition, radiation light 90d including first radiation light 91d and second radiation light 92d is emitted from wavelength conversion element 4a through the face opposite to the face on which emission light 11 is incident. In other words, radiation light 90d is emitted toward semiconductor light emitting device 1. First radiation light 91d and second radiation light 92d are smaller than first radiation light 91 and second radiation light 92 in the light intensity. Radiation light 90d including first radiation light 91d and second radiation light 92d is light which is radiation light 90 emitted from wavelength conversion component 4 and not used by the projection component (unnecessary light), and is reflected by reflective component 23 to be incident on photodetector 7.

At this time, a portion of wavelength conversion element 4a in proximity to an illuminated region to which emission light 11 is emitted generates heat due to stokes loss that is energy loss that occurs when emission light 11 is converted to second radiation light 92, and the temperature locally increases.

This heat is dissipated from reflective component 4b and supporting component 4c to holding component 26. However, there are instances where a temperature of wavelength conversion element 4a unintentionally increases due to, for example, an increase in crystal defects caused by consecutive emission of light having a high energy density to wavelength conversion element 4a.

In this case, as illustrated in (b) in FIG. 22, there are instances where a binder or a phosphor particle rapidly increases in temperature, and this increase in temperature locally disassembles and evaporates the binder to generate a hollow space or the like.

When the operation is continued in the state illustrated in (b) in FIG. 22 and emission light 11 is continued to be emitted to wavelength conversion component 4, wavelength conversion element 4a in an illuminated region to which emission light 11 is emitted is completely blown off, and emission light 11 is directly emitted to the outside. In such a state as described above, radiation light which is high in monochromaticity, directivity, and an energy as with emission light 11 is emitted from light source device 101B', leading to a dangerous state.

At this time, in the state illustrated in (c) in FIG. 22, the amount of light of radiation light 90b emitted toward semiconductor light emitting device 1 (toward photodetector 7) also changes. Accordingly, it is possible to accurately detect the state of wavelength conversion component 4, by continuously detecting, by photodetector 7, radiation light 90b emitted from wavelength conversion component 4. More specifically, it is possible to detect abnormal deterioration of wavelength conversion component 4 based on a change in a voltage corresponding to the light intensity of radiation light 90b detected by photodetector 7. When abnormal deterioration of wavelength conversion component 4 is detected, driving of semiconductor light emitting device 1 is stopped.

As described above, light source device 101B' according to the present variation also yields the advantageous effects same as or similar to the advantageous effects of light source device 101B according to Embodiment 3 described above.

In addition, according to the present variation, wavelength conversion component 4 emits radiation light 90 from a face opposite to a face on which emission light 11 emitted from semiconductor light emitting device 1 is incident.

With this configuration, it is possible to implement light source device 101B' having a configuration in which excitation light is transmitted through the wavelength conversion component and becomes radiation light.

### (Embodiment 4)

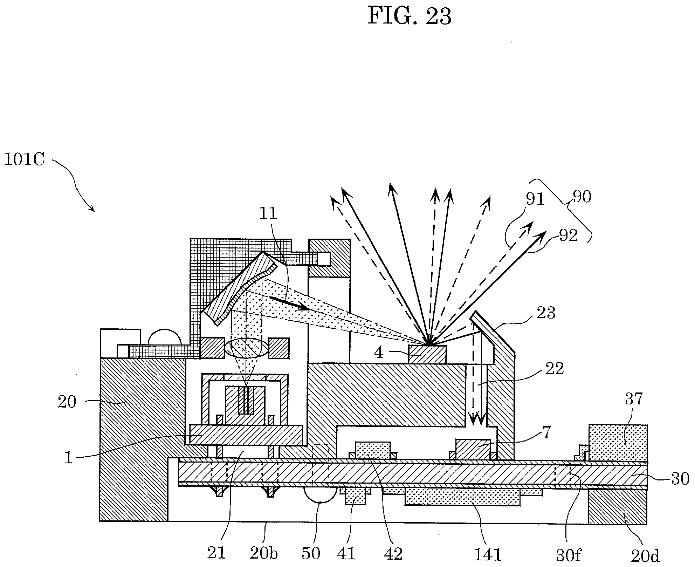

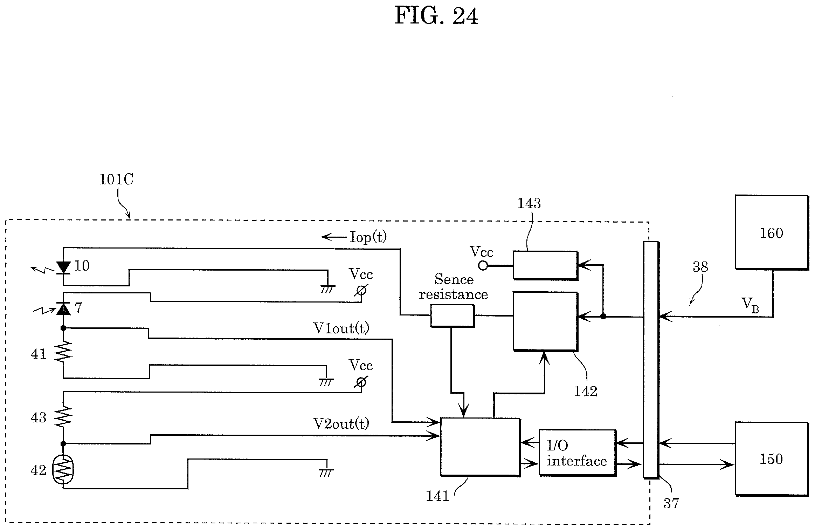

The following describes light source device 101C according to Embodiment 4, with reference to FIG. 23 and FIG. 24. FIG. 23 is a schematic cross-sectional diagram which illustrates a configuration of light source device 101C according to Embodiment 4. FIG. 24 is a circuit block diagram which illustrates a circuit configuration of light source device 101C according to Embodiment 4, and a circuit configuration of a driving unit for driving light source device 101C according to Embodiment 4.

As illustrated in FIG. 23 and FIG. 24, in light source device 101C according to the present embodiment, semiconductor light emitting device 1 and wavelength conversion component 4 are fixed to supporting component 20, semiconductor light emitting device 1, photodetector 7, and temperature detection element 42 are disposed on first wiring board 30, and further, a portion or the entirety of controller 140 is disposed on first wiring board 30. In other words, in light source device 101C according to the present embodiment, a portion or the entirety of controller 140 which controls semiconductor light emitting device 1 based on intensity of light incident on photodetector 7 is mounted as an internal component of light source device 101C.

More specifically, a portion or the entirety of microcontroller 141, step-down circuit 142, step-down circuit 143, etc. which are included in controller 140 is mounted on first wiring board 30. Microcontroller 141 includes a packaged integrated circuit (IC).

Semiconductor light emitting device 1, photodetector 7, and temperature detection element 42 are mounted on first wiring board 30 on the side of supporting component 20. Photodetector 7 and temperature detection element 42 are disposed in a recess which is continuous with second opening portion 22. In this case, temperature detection element 42 is disposed in proximity to semiconductor light emitting device 1. In other words, temperature detection element 42 is disposed between semiconductor light emitting device 1 and photodetector 7. According to the present embodiment, microcontroller 141 is mounted on a face of first wiring board 30 on the side opposite to the side of supporting component 20.

In addition, resistive element 41 and resistive element 43 are also mounted on first wiring board 30. Resistive element 41 converts current generated when photodetector 7 receives light into a voltage, thereby generating signal V1_{OUT}(t). Resistive element 43 divides a voltage output from temperature detection element 42, thereby generating signal V2_{OUT}(t).

Microcontroller 141 receives signals (V1_{OUT}(t), V2_{OUT}(t)) generated by resistive element 41 and resistive element 43, and determines the state of light source device 101C. When abnormality is found, microcontroller 141 sets current I_{OP}(t) output from step-down circuit 142 to 0 ampere to stop driving of semiconductor light emitting device 1.

Photodetector 7 disposed at a location off a light path of light which is radiation light 90 and used as illumination light (usable radiation light) receives light which is radiation light 90 and not used as illumination light (unnecessary light). A portion of the unnecessary light is reflected by reflective component 23, passes through second opening portion 22, and is guided to photodetector 7. It should be noted that, although reflective component 23 is included in supporting component 20 according to the present embodiment, reflective component 23 may be separate from supporting component 20.

An abnormal state of wavelength conversion component 4 is determined by microcontroller 141 based on the amount of light receive by photodetector 7 which is unnecessary radiation light 90, and semiconductor light emitting device 1 is turned on or off according to the result of the determination by microcontroller 141, thereby inhibiting radiation light which is high in monochromaticity, directivity, and a energy density as with emission light 11 emitted from semiconductor light emitting device 1 from being emitted to the outside of light source device 101C.

As described above, with light source device 101C according to the present embodiment, as with Embodiment 1 to Embodiment 3, photodetector 7 is disposed at a location off a light path of usable radiation light which is light emitted from wavelength conversion component 4 to a space, and used as illumination light 110.

With this configuration, it is possible to accurately detect abnormal deterioration of wavelength conversion component 4 by photodetector 7 to implement light source device 101C with high safety, as well as possible, even when photodetector 7 is used, to inhibit uneveness in light intensity from being generated in an illuminated region of illumination light 110 due to photodetector 7. Furthermore, since it is also possible to implement light source device 101C which is small in size, a projection device which includes light source device 101C can be small in size as well.

In addition, according to the present embodiment, microcontroller 141, a step-down circuit, etc. which are included in controller 140 are disposed on first wiring board 30. Microcontroller 141 is capable of receiving signals (V1_{OUT}(t), V2_{OUT}(t)) related to the amount of light incident on photodetector 7 or a temperature of temperature detection element 42, and determining the state of light source device 101C. When abnormality is found, microcontroller 141 is capable of setting current I_{OP}(t) to 0 by controlling the step-down circuit to stop driving of semiconductor light emitting device 1.

In addition, with this configuration, it is possible to detect a temperature in proximity to semiconductor light emitting device 1 by temperature detection element 42. Accordingly, it is possible to determine whether or not wavelength conversion component 4 is abnormally deteriorated, in consideration of temperature dependency of light emission of semiconductor light emitting device 1. Accordingly, it is possible to further accurately detect abnormal deterioration of wavelength conversion component 4.

As described above, with light source device 101C according to the present embodiment, light source device 101C is capable of performing by itself a safety function for preventing emission light 11 transmitted by semiconductor light emitting device 1 from being directly emitted to the outside, without depending on control outside light source device 101C.

### (Embodiment 5)

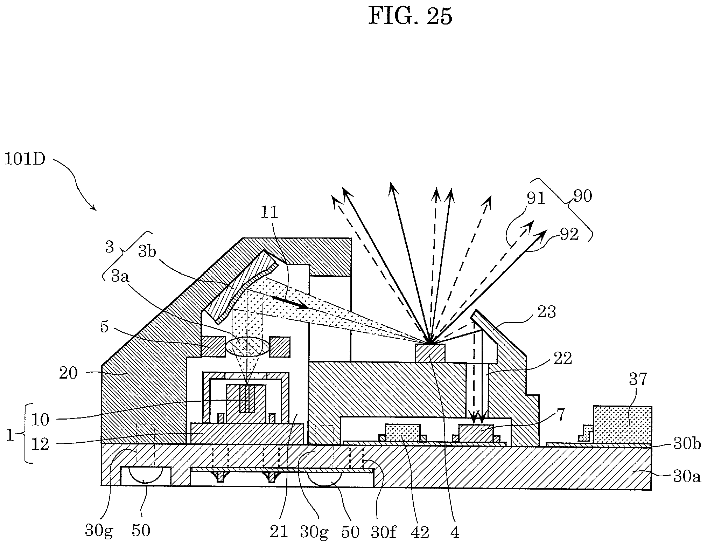

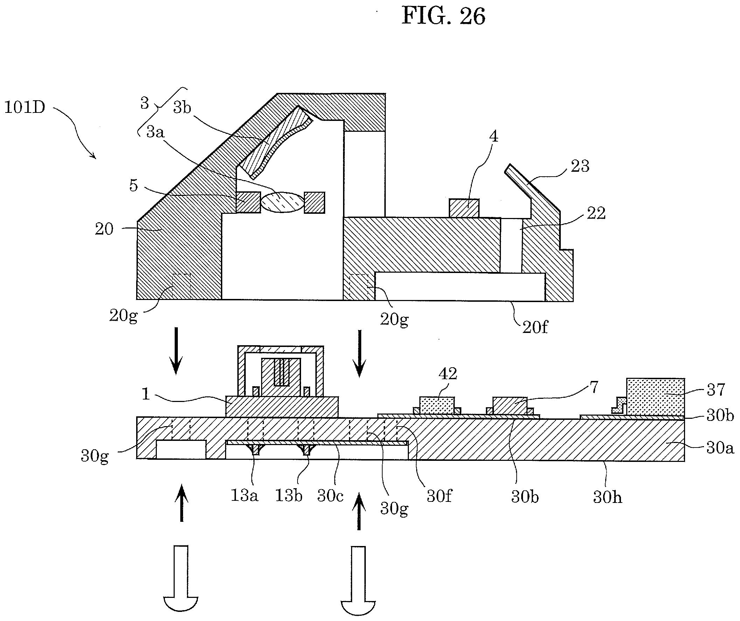

The following describes light source device 101D according to Embodiment 5, with reference to FIG. 25 and FIG. 26. FIG. 25 is a schematic cross-sectional diagram which illustrates a configuration of light source device 101D according to Embodiment 5. FIG. 26 is a diagram for explaining a method of manufacturing light source device 101D according to Embodiment 5.

Light source device 101D illustrated in FIG. 25 according to the present embodiment has a metal core substrate as first wiring board 30 included in light source device 101C according to Embodiment 4. More specifically, board 30a of first wiring board 30 is the metal core substrate in which, for example, copper or aluminum is included as a base material, and wiring layers 30b and 30c including an insulating film and a metal pattern are formed on a portion of a surface.

Light source device 101D having the above-described configuration can be assembled as illustrated in FIG. 26. More specifically, wavelength conversion component 4 is attached to one side of supporting component 20, and first wiring board 30 on which semiconductor light emitting device 1, photodetector 7, and temperature detection element 42 are mounted is attached to the other side of supporting component 20. At this time, semiconductor light emitting device 1 is mounted so as to directly be closely attached to first wiring board 30 in advance. First wiring board 30 is fixed to supporting component 20 by screw 50.

According to the present embodiment, photodetector 7 disposed at a location off a light path of light which is radiation light 90 and used as illumination light (usable radiation light) receives light which is radiation light 90 and not used as illumination light (unnecessary light), in the same manner as Embodiment 4. It should b be noted that a portion of the unnecessary light is reflected by reflective component 23, passes through second opening portion 22, and is guided to photodetector 7.

Controller 140 determines an abnormal state of wavelength conversion component 4 based on the amount of unnecessary light received by photodetector 7, and turns on or off semiconductor light emitting device 1 according to the result of the determination by controller 140, thereby making it possible to inhibit radiation light which is high in monochromaticity, directivity, and an energy density as with emission light 11 emitted from semiconductor light emitting device 1 from being emitted to the outside of light source device 101D.

As described above, with light source device 101D according to the present embodiment, as with Embodiment 1 to Embodiment 4, photodetector 7 is disposed at a location off a light path of usable radiation light which is light emitted from wavelength conversion component 4 to a space, and used as illumination light 110.

With this configuration, it is possible to accurately detect abnormal deterioration of wavelength conversion component 4 by photodetector 7 to implement light source device 101D with high safety, as well as possible, even when photodetector 7 is used, to inhibit uneveness in light intensity from being generated in an illuminated region of illumination light 110 due to photodetector 7. Furthermore, since it is also possible to implement light source device 101D which is small in size, a projection device which includes light source device 101D can be small in size as well.

In addition, according to the present embodiment, first wiring board 30 is formed using a metal core substrate which excels in conducting heat. Semiconductor light emitting device 1 is mounted so as to be closely attached to first wiring board 30. A surface of first wiring board 30 opposite to the surface of first wiring board 30 on which semiconductor light emitting device 1 is mounted is heat dissipation surface 30h.

With this configuration, it is possible to implement light source device 101D which excels in heat dissipation property of semiconductor light emitting device 1.

### (Embodiment 6)

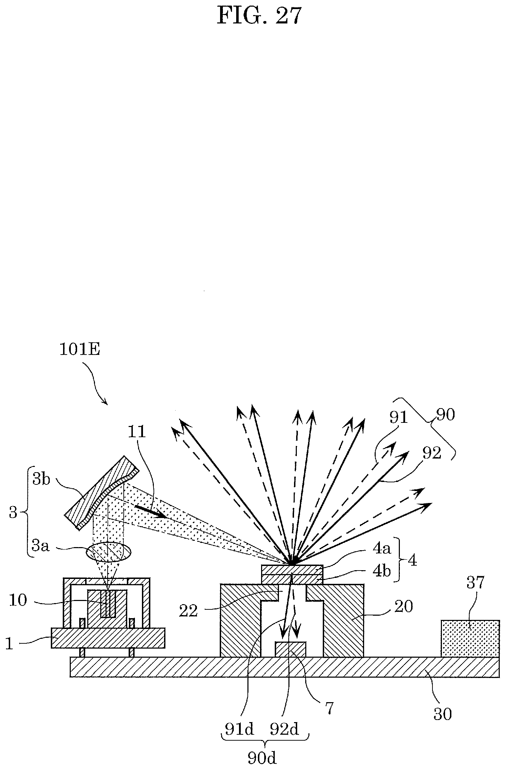

The following describes light source device 101E according to Embodiment 6, with reference to FIG. 27. FIG. 27 is a schematic cross-sectional diagram which illustrates a configuration of light source device 101E according to Embodiment 6.

According to the present embodiment, wavelength conversion component 4 includes wavelength conversion element 4a formed by, for example, mixing a phosphor particle with a binder such as silicone, disposed on reflective component 4b formed by forming a reflection film, which is not illustrated in the diagram, on a surface of a transparent substrate which is high in thermal conductivity. More specifically, reflective component 4b includes a dielectric multi-layer is formed, for example, on a sapphire substrate or a silicon carbide crystal substrate.

As illustrated in FIG. 27, in light source device 101E according to the present embodiment as well, photodetector 7 is disposed at a location off a light path of light which is radiation light 90 emitted from wavelength conversion component 4 and used as illumination light (usable radiation light). However, according to the present embodiment, photodetector 7 receives, through second opening portion 22 of supporting component 20, a portion of radiation light 90d which is emitted toward a side opposite to a side to which usable radiation light emitted toward projection component (not illustrated) travels.

It should be noted that light incident on photodetector 7 is unnecessary light which is a portion of radiation light 90 emitted from wavelength conversion component 4 and not used as illumination light, and is, for example, light leaking from reflective component 4b of wavelength conversion component 4.

As described above, in the present embodiment as well, photodetector 7 disposed at a location off a light path of light which is radiation light 90 and used as illumination light (usable radiation light) receives light which is radiation light 90 and not used as illumination light (unnecessary light).

Controller 140 determines an abnormal state of wavelength conversion component 4 based on the amount of light received by photodetector 7, and turns on or off semiconductor light emitting device 1 according to the result of the determination by controller 140, thereby making it possible to inhibit radiation light which is high in monochromaticity, directivity, and an energy density as with emission light 11 emitted from semiconductor light emitting device 1 from being emitted to the outside of light source device 101E.

As described above, with light source device 101E according to the present embodiment, as with Embodiment 1 to Embodiment 5, photodetector 7 is disposed at a location off a light path of usable radiation light which is light emitted from wavelength conversion component 4 to a space, and used as illumination light 110.

With this configuration, it is possible to accurately detect abnormal deterioration of wavelength conversion component 4 by photodetector 7 to implement light source device 101E with high safety, as well as possible, even when photodetector 7 is used, to inhibit uneveness in light intensity from being generated in an illuminated region of illumination light 110 due to photodetector 7. Furthermore, since it is also possible to implement light source device 101E which is small in size, a projection device which includes light source device 101E can be small in size as well.

### (Embodiment 7)

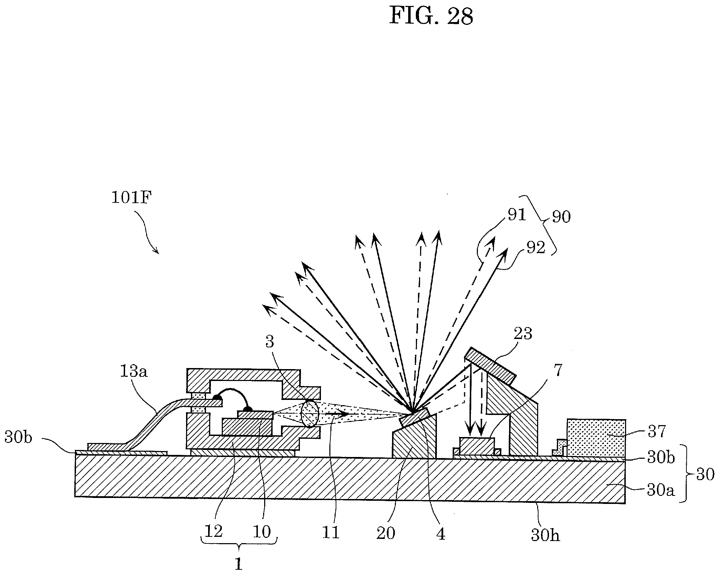

The following describes light source device 101F according to Embodiment 7, with reference to FIG. 28. FIG. 28 is a schematic cross-sectional diagram which illustrates a configuration of light source device 101F according to Embodiment 7.

In light source device 101F according to embodiment 1 described above, semiconductor light emitting element 10 is packaged using package 12 which is a TO-CAN package. However, in light source device 101F according to the present embodiment, semiconductor light emitting element 10 is semiconductor light emitting device 1 which is packaged using package 12 which is other than a TO-CAN package. More specifically, in the same manner as the configuration of a package referred to as a butterfly type, lead pin 13a is disposed on a side face of package 12 which is a box-type package. Semiconductor light emitting element 10 is mounted on a bottom surface of package 12 via a sub-mount or the like. Condenser lens 3 which is, for example, a convex lens is fixed to a side face of package 12 on which lead pin 13a is not disposed.

First wiring board 30 is a metal core substrate in which: wiring layer 30b is formed on only one of the faces of board 30a formed of, for example, aluminum or copper. Unlike Embodiment 5, semiconductor light emitting device 1 is mounted on the same face as the face on which wavelength conversion component 4 and photodetector 7 are mounted, without lead pin 13a being penetrating through first wiring board 30. In another example, semiconductor light emitting device 1, photodetector 7, and external connecting member 37 are mounted on the same face of first wiring board 30, and electrically connected on the same face. Furthermore, the wavelength conversion component and the reflective component are also disposed on the same face. In this case, wavelength conversion component 4 is tilted to the side on which semiconductor light emitting element 10 is disposed, and fixed, such that emission light 11 is easily condensed onto wavelength conversion component 4.

According to the present embodiment, emission light 11 emitted from semiconductor light emitting element 10 is condensed by condenser lens 3 onto wavelength conversion component 4, and emitted upward as radiation light 90.

At this time, with light source device 101F according to the present embodiment, as with Embodiment 1 to Embodiment 6, photodetector 7 is disposed at a location off a light path of usable radiation light which is light emitted from wavelength conversion component 4 to a space, and used as illumination light 110.

With this configuration, it is possible to accurately detect abnormal deterioration of wavelength conversion component 4 by photodetector 7 to implement light source device 101F with high safety, as well as possible, even when photodetector 7 is used, to inhibit uneveness in light intensity from being generated in an illuminated region of illumination light 110 due to photodetector 7. Furthermore, since it is also possible to implement light source device 101F which is small in size, a projection device which includes light source device 101F can be small in size as well.

In addition, according to the present embodiment, semiconductor light emitting device 1, photodetector 7, and external connecting member 37 are mounted on the same face of first wiring board 30, and electrically connected on the same face.

With this configuration, it is possible to simplify the configuration and manufacturing processes of light source device 101F.

### (Embodiment 8)

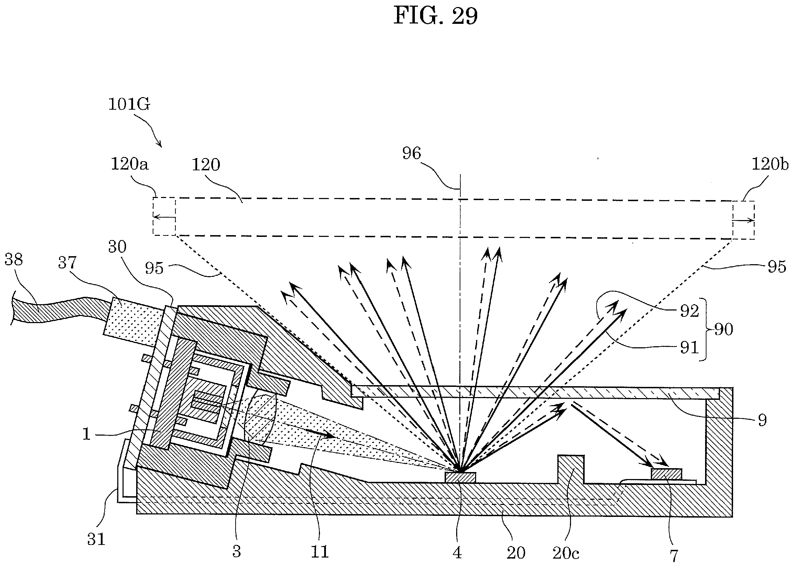

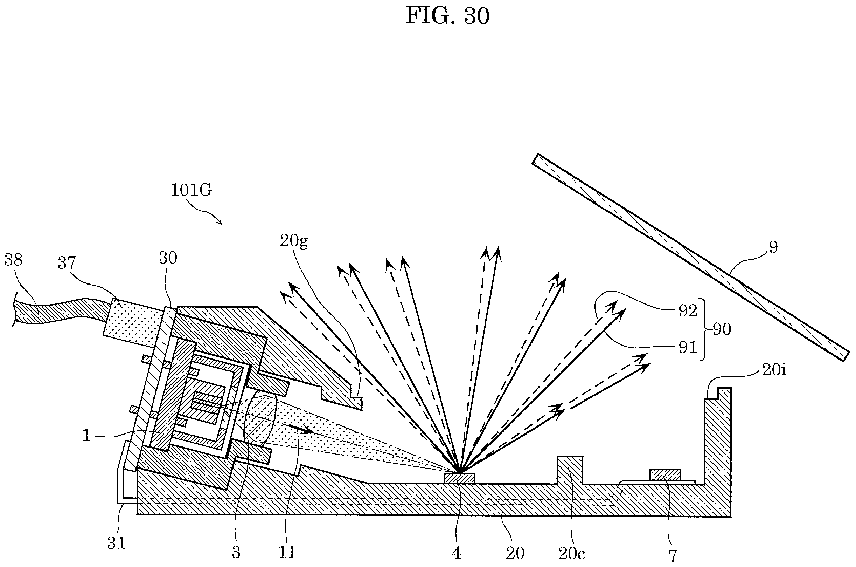

The following describes light source device 101G according to Embodiment 8, with reference to FIG. 29 and FIG. 30. FIG. 29 is a schematic cross-sectional diagram which illustrates a configuration of light source device 101G according to Embodiment 8. FIG. 30 is a diagram for explaining a safety function of light source device 101G according to Embodiment 8.

As illustrated in FIG. 29, light source device 101G according to the present embodiment includes transparent cover component 9 in addition to the components included in light source device 101 according to Embodiment 1. Transparent cover component 9 covers wavelength conversion component 4 and photodetector 7 such that an opening of supporting component 20 is closed. Transparent cover component 9 is fixed to supporting component 20 such that a surface of transparent cover component 9 is substantially parallel with a lower face of supporting component 20, according to the present embodiment. As transparent cover component 9, for example, a glass plate (cover glass) or a transparent resin plate which includes an antireflection film having a surface reflectance that is, for example, in a range of from 0.1% to 2% is formed on the both faces can be used.

Light which is radiation light 90 emitted from wavelength conversion component 4 and passes in usable radiation range 95 is projected to the outside by projection component 120. Usable radiation range 95 is a range of light which is incident on projection component 120.

Transparent cover component 9 is a light-transmissive component which is located above wavelength conversion component 4, and transmits radiation light 90 emitted from wavelength conversion component 4. According to the present embodiment, a portion of radiation light 90 emitted from wavelength conversion component 4 is reflected by a surface of transparent cover component 9. In other words, transparent cover component 9 functions as a transmitting component which transmits light which is light emitted from wavelength conversion component 4 and used as illumination light (usable radiation light), as well as a reflective component which reflects a portion of light which is light emitted from wavelength conversion component 4 and not used as illumination light (unnecessary light).

Photodetector 7 receives a portion of radiation light 90 reflected by transparent cover component 9. More specifically, photodetector 7 receives light which is radiation light 90 and not used as illumination light (unnecessary light).

With light source device 101G configured in this manner, when there is a defect in transparent cover component 9, such as the case where transparent cover component 9 is detached or broken, or transparent cover component 9 is displaced, the amount of received radiation light 90 which is radiation light 90 incident on photodetector 7 changes. For example, when transparent cover component 9 is detached as illustrated in FIG. 30, radiation light 90 is not incident on photodetector 7, and thus the amount of light received by photodetector 7 decreases. As described above, it is determined that there is a defect in transparent cover component 9, such as the case where transparent cover component 9 is detached or broken, by detecting a change in the amount of light received by photodetector 7, and the operation of semiconductor light emitting device 1 is stopped.

As described above, in the present embodiment as well, photodetector 7 disposed at a location off a light path of light which is radiation light 90 and used as illumination light (usable radiation light) receives light reflected by transparent cover component 9 as light which is radiation light 90 and not used as illumination light (unnecessary light).

Controller 140 determines an abnormal state of wavelength conversion component 4 based on the amount of unnecessary light received by photodetector 7, and turns on or off semiconductor light emitting device 1 according to the result of the determination by controller 140, thereby making it possible to inhibit radiation light which is high in monochromaticity, directivity, and an energy density as with emission light 11 emitted from semiconductor light emitting device 1 from being emitted to the outside of light source device 101G.

As described above, with light source device 101G according to the present embodiment, as with Embodiment 1 to Embodiment 7, photodetector 7 is disposed at a location off a light path of usable radiation light which is light emitted from wavelength conversion component 4, and used as illumination light 110.

With this configuration, it is possible to accurately detect abnormal deterioration of wavelength conversion component 4 by photodetector 7 to implement light source device 101G with high safety, as well as possible, even when photodetector 7 is used, to inhibit uneveness in light intensity from being generated in an illuminated region of illumination light 110 due to photodetector 7. Furthermore, since it is also possible to implement light source device 101G which is small in size, a projection device which includes light source device 101G can be small in size as well.

In addition, according to the present embodiment, wavelength conversion component 4 and photodetector 7 are protected by transparent cover component 9.

With this configuration, it is possible to implement light source device 101G which excels in dustproof property and waterproof property. In particular, since photodetector 7 is protected by transparent cover component 9, it is possible to inhibit foreign particles from being attached to the surface of photodetector 7. Accordingly, it is possible to accurately detect abnormality of wavelength conversion component 4.

In addition, according to the present embodiment, it is also possible to detect, by photodetector 7, a defect of transparent cover component 9 such as the case where transparent cover component 9 is detached or broken.

This allows establishing the safety function as well as implementing light source device 101G with high safety.

In addition, according to the present embodiment, transparent cover component 9 functions as a transmitting component which transmits light which is used as illumination light (usable radiation light), as well as a reflective component which reflects a portion of light which is not used as illumination light (unnecessary light).

With this configuration, it is possible to reflect a portion of light (unnecessary light) which is not used as illumination light so as to be incident on photodetector 7 without using reflective component 23, while protecting wavelength conversion component 4 and photodetector 7. Accordingly, it is possible to implement light source device 101G which is highly reliable and small in size.

### (Variation of Embodiment 8)

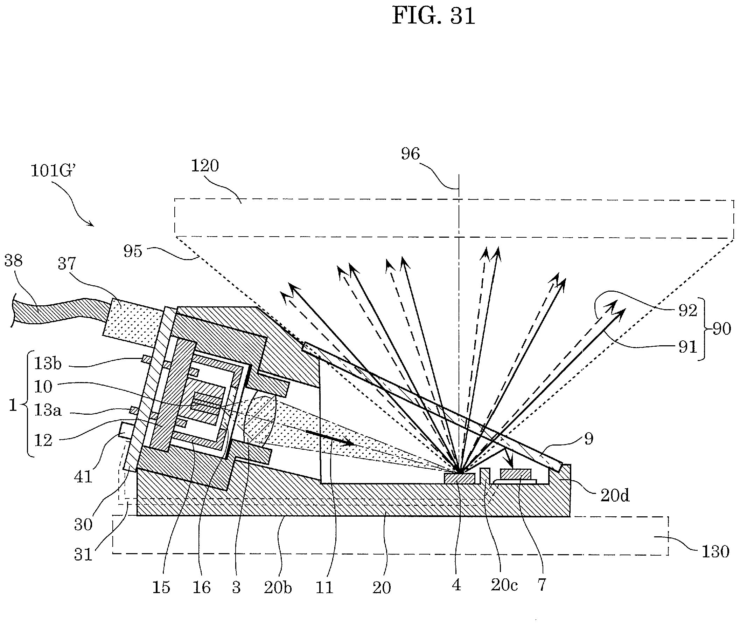

The following describes light source device 101G' according to a variation example of Embodiment 8, with reference to FIG. 31. FIG. 31 is a schematic cross-sectional diagram which illustrates a configuration of light source device 101G' according to the variation example of Embodiment 8.

Light source device 101G according to Embodiment 8 described above is disposed such that transparent cover component 9 is substantially parallel with the lower face of supporting component 20. However, light source device 101G' according to the present variation is disposed such that transparent cover component 9 is tilted with respect to the lower face of supporting component 20 as illustrated in FIG. 31. More specifically, transparent cover component 9 is tilted such that an end portion of transparent cover component 9 on the side close to semiconductor light emitting device 1 is positioned higher than the other end portion of transparent cover component 9.

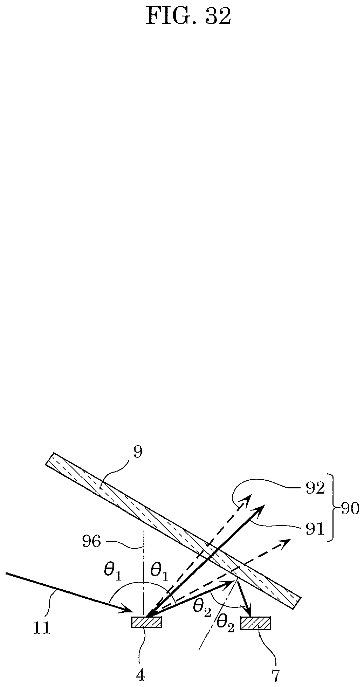

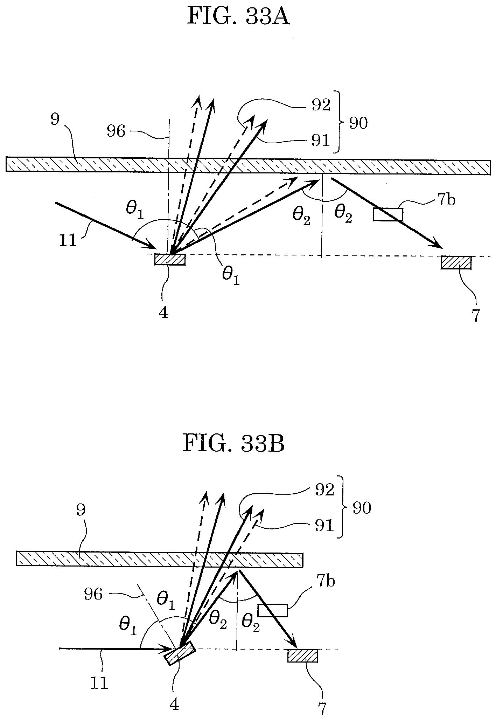

The following describes a relationship between the tilt of transparent cover component 9 and the length of light path from wavelength conversion component 4 and photodetector 7, with reference to FIG. 32, FIG. 33A, and FIG. 33B. FIG. 32, FIG. 33A, and FIG. 33B are diagrams for explaining the relationship between the tilt of transparent cover component 9 and the length of light path from wavelength conversion component 4 and photodetector 7. FIG. 32 illustrates a positional relationship of wavelength conversion component 4, transparent cover component 9, and photodetector 7 in light source device 101G' according to Variation of Embodiment 8. FIG. 33A and FIG. 33B respectively illustrate a positional relationship of wavelength conversion component 4, transparent cover component 9, and photodetector 7 in Comparison 1, and a positional relationship of wavelength conversion component 4, transparent cover component 9, and photodetector 7 in Comparison 2. In the comparison described below, the case where emission light 11 is in incident on and reflected by wavelength conversion component 4 at incident angle θ1, the reflected incident light (emission light 11) is incident on and reflected by transparent cover component 9 at incident light θ2, and photodetector 7 is disposed in the light path will be described.

In Comparison 1 illustrated in FIG. 33A, wavelength conversion component 4, transparent cover component 9, and photodetector 7 are arranged in parallel with one another. In this case, incident angle θ1 is substantially equivalent to incident angle θ2. In addition, in Comparison 2 illustrated in FIG. 33B, although transparent cover component 9 and photodetector 7 are parallel with each other, wavelength conversion component 4 is disposed so as to be tilted to the side on which semiconductor light emitting element 1 is disposed, and wavelength conversion component 4 is tilted with respect to transparent cover component 9 and photodetector 7. In this case, incident angle θ2 is smaller than incident angle θ1.

Comparison between FIG. 33A and FIG. 33B shows that the light path from wavelength conversion component 4 to photodetector 7 in Comparison 2 illustrated in FIG. 33B is shorter than the light path from wavelength conversion component 4 to photodetector 7 in Comparison 1 illustrated in FIG. 33A. In other words, it is possible to reduce the length of the light path from wavelength conversion component 4 to photodetector 7, by causing wavelength conversion component 4 to be tilted to the side on which semiconductor light emitting element 1 is disposed. It is possible to yield the same advantageous effect as above, by disposing photodetector 7 at position 7b which is closer to transparent cover component 9 than a position of photodetector 7 of the above-described example.

In addition, according to the present embodiment illustrated in FIG. 32, although wavelength conversion component 4 and photodetector 7 are arranged in parallel with each other, transparent cover component 9 is disposed so as to be tilted with respect to wavelength conversion component 4 and photodetector 7.

Comparison between FIG. 32 and FIG. 33B shows that the light path from wavelength conversion component 4 to photodetector 7 in the present embodiment illustrated in FIG. 32 is shorter than the light path from wavelength conversion component 4 to photodetector 7 in Comparison 2 illustrated in FIG. 33B. In other words, it is possible to further reduce the length of the light path from wavelength conversion component 4 to photodetector 7, by causing transparent cover component 9 to be tilted with respect to the lower surface of supporting component 20.

As described above, according to the present variation, lighting device 101G' is capable of producing an advantageous effect same as or similar to the advantageous effect according to Embodiment 8.

In addition, according to the present variation, transparent cover component 9 is disposed so as to be tilted with respect to the lower surface of supporting component 20.

With this configuration, it is possible to reduce the length of the light path from wavelength conversion component 4 to photodetector 7 compared to the length of the light path from wavelength conversion component 4 to photodetector 7 in light source device 101G of Embodiment 8. Accordingly, it is possible to decrease the size of the light source device.

### (Embodiment 9)

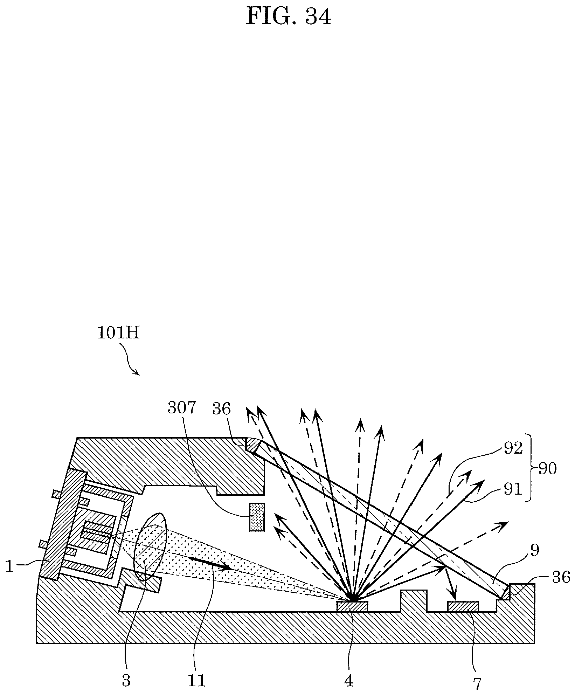

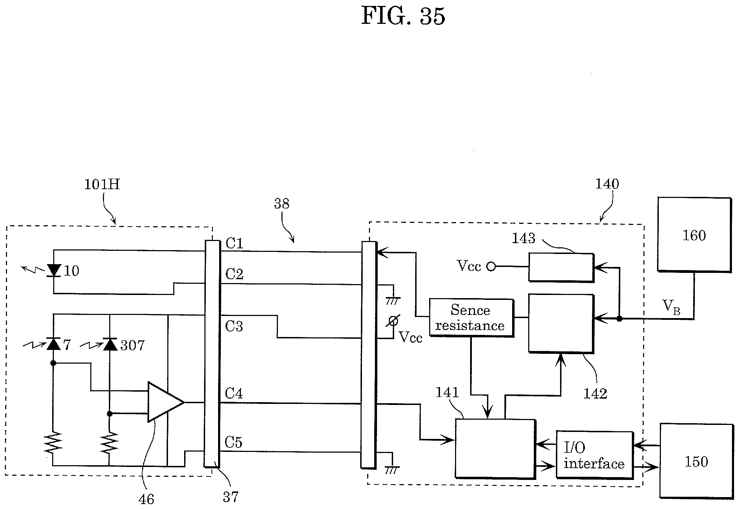

The following describes light source device 101H according to Embodiment 9, with reference to FIG. 34 and FIG. 35. FIG. 34 is a schematic cross-sectional diagram which illustrates a configuration of light source device 101H according to Embodiment 9. FIG. 35 is a circuit block diagram which illustrates a circuit configuration of light source device 101H according to Embodiment 9, and a circuit configuration of a driving unit for driving light source device 101H.

As illustrated in FIG. 34, light source device 101H according to the present embodiment further includes photodetector 307 in addition to the components included in light source device 101G' according to the variation example of Embodiment 8. Photodetector 307 receives a portion of radiation light 90. More specifically, photodetector 307 receives first radiation light 91c and second radiation light 92c which are emitted to the outside of usable radiation range 95 on the side close to semiconductor light emitting device 1 as illustrated in FIG. 5B and FIG. 5C. It should be noted that, as described above, photodetector 7 receives first radiation light 91b and second radiation light 92b which are emitted to the outside of usable radiation range 95 on the side opposite to the side closer to semiconductor light emitting device 1 as illustrated in FIG. 5B and FIG. 5C

As illustrated in FIG. 35, according to the present embodiment, a signal output from each of photodetector 7 (a first photodetector) and photodetector 307 (a second photodetector) is received by, for example, difference amplifier 46 to generate difference signal C4, and difference signal C4 that has been generated is output to controller 140, to determine whether there is abnormality in wavelength conversion component 4 or there is abnormality in transparent cover component 9, thereby controlling the operation of light source device 101H.

In this case, as illustrated in FIG. 5B and FIG. 5C, radiation light (first radiation light 91c and second radiation light 92c) which is emitted to the outside of usable radiation range 95 on the side close to semiconductor light emitting device 1 and received by photodetector 307 and radiation light (first radiation light 91b and second radiation light 92b) which is emitted to the outside of usable radiation range 95 on the side opposite to the side closer to semiconductor light emitting device 1 and received by photodetector 7 are compared, thereby making it possible to determine whether there is abnormality in wavelength conversion component 4 or there is abnormality in transparent cover component 9.

As a result, as illustrated in (a) to (c) in FIG. 6, the ratio of output of photodetector 307 to output of photodetector 7 changes when wavelength conversion component 4 is damaged. Accordingly, it is possible to further accurately detect damage in wavelength conversion component 4.

In the present embodiment as well, photodetector 7 disposed at a location off a light path of light which is radiation light 90 and used as illumination light (usable radiation light) receives light reflected by transparent cover component 9 as light which is radiation light 90 and not used as illumination light (unnecessary light).

Controller 140 determines an abnormal state of wavelength conversion component 4 based on the amount of unnecessary light received by photodetector 7, and turns on or off semiconductor light emitting device 1 according to the result of the determination by controller 140, thereby making it possible to inhibit radiation light which is high in monochromaticity, directivity, and an energy density as with emission light 11 emitted from semiconductor light emitting device 1 from being emitted to the outside of light source device 101H.

As described above, with light source device 101H according to the present embodiment, as with Embodiment 1 to Embodiment 8, photodetector 7 is disposed at a location off a light path of usable radiation light which is light emitted from wavelength conversion component 4, and used as illumination light 110.

With this configuration, it is possible to accurately detect abnormal deterioration of wavelength conversion component 4 by photodetector 7 to implement light source device 101H with high safety, as well as possible, even when photodetector 7 is used, to inhibit uneveness in light intensity from being generated in an illuminated region of illumination light 110 due to photodetector 7. Furthermore, since it is also possible to implement light source device 101H which is small in size, a projection device which includes light source device 101H can be small in size as well.

In addition, according to the present embodiment, not only photodetector 7 but also photodetector 307 receives a portion of radiation light 90.

In this manner, it is possible to further accurately detect abnormal deterioration of wavelength conversion component 4, and thus it is possible to implement light source device 101H with higher safety.

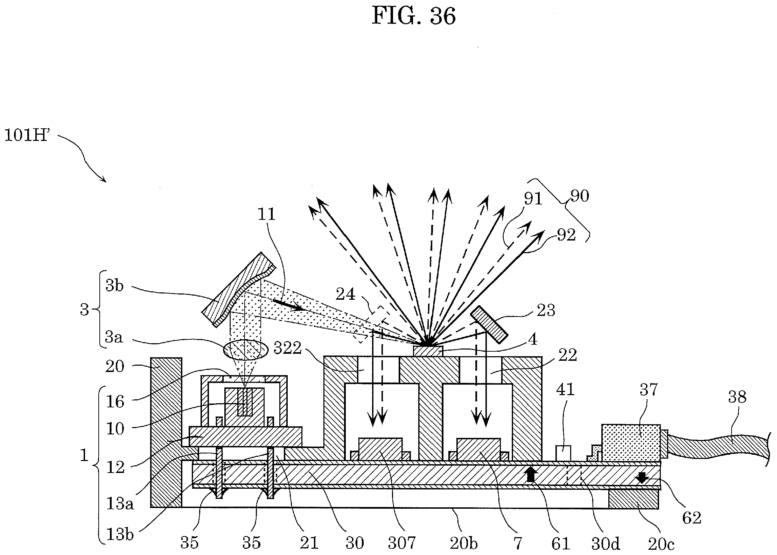

In addition, as a light source device including photodetector 7 and photodetector 307, light source device 101H' having a configuration as illustrated in FIG. 36 may be employed. Light source device 101H' as illustrated in FIG. 36 includes supporting component 20 in which second opening portion 22 and opening portion 322 are provided, and reflective component 23 and reflective component 24 are fixed by supporting components which are not illustrated in the diagram, above second opening portion 22 and opening portion 322, respectively. Reflective component 24 reflects a portion or the entirety of radiation light (first radiation light 91c and second radiation light 92c) which is emitted to the outside of usable radiation range 95 on the side close to semiconductor light emitting device 1, and guides to photodetector 307 mounted on first wiring board 30 through opening portion 322. It should be noted that reflective component 24 is disposed at a position not interfering with emission light 11.

With this configuration, it is possible to mount both photodetector 7 and photodetector 307 on first wiring board 30. Accordingly, it is possible to easily configure light source device 101H.

### (Embodiment 10)

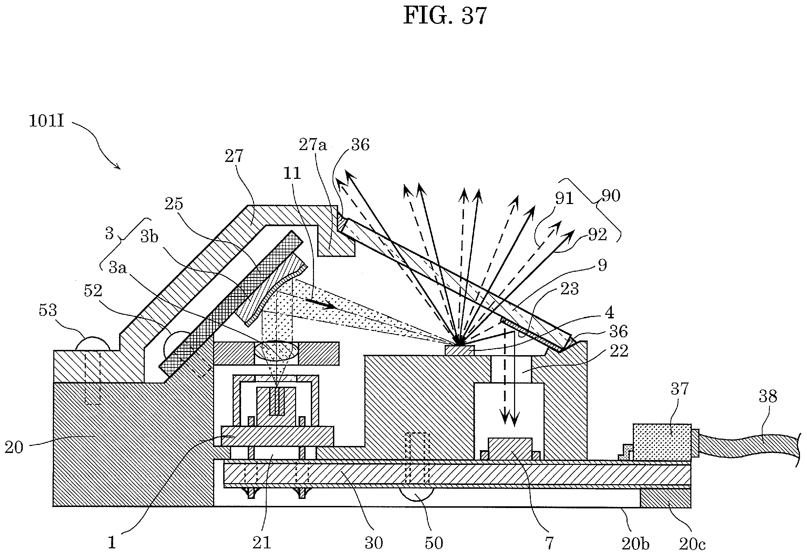

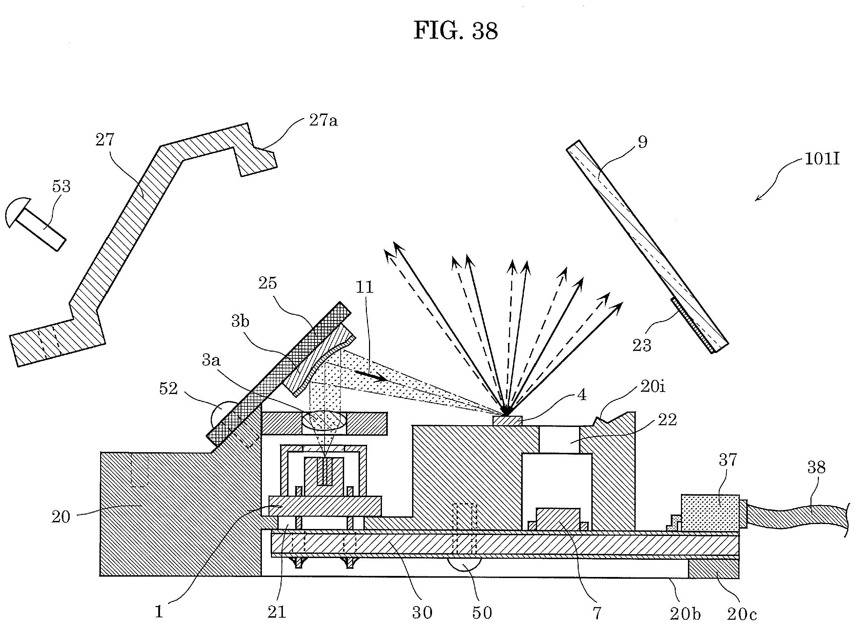

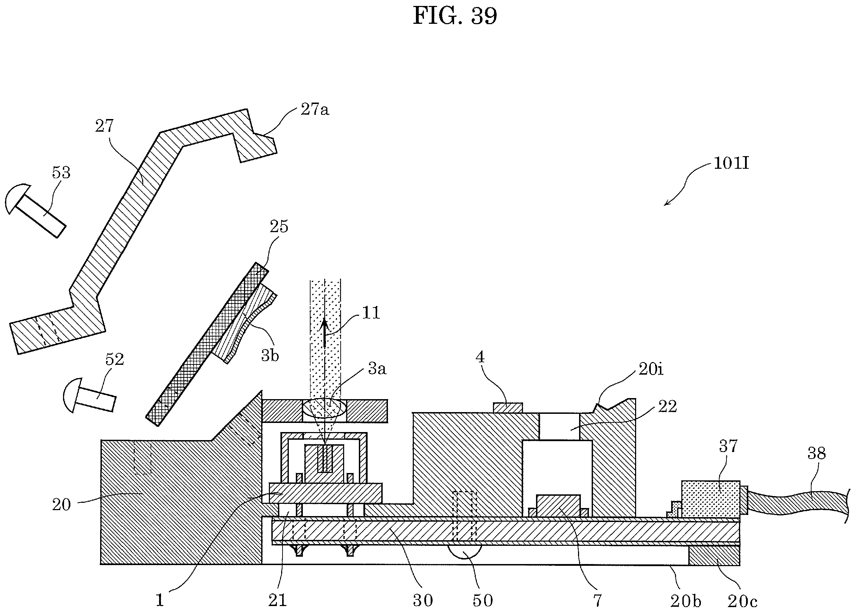

The following describes light source device 101I according to Embodiment 10 with reference to FIG. 37 to FIG. 39. FIG. 37 is a schematic cross-sectional diagram which illustrates a configuration of light source device 101I according to Embodiment 10. FIG. 38 and FIG. 39 are each diagrams for explaining a safety function of light source device 101I according to Embodiment 10.

As illustrated in FIG. 37, light source device 101I according to the present embodiment further includes transparent cover component 9 and cover component 27 in addition to the components included in light source device 101A according to Embodiment 2.

Transparent cover component 9 is disposed so as to close an opening formed by supporting component 20 and cover component 27, and covers wavelength conversion component 4. As transparent cover component 9, for example, a glass plate or a transparent resin plate can be employed. An edge of transparent cover component 9 is fixed to supporting component 20 and cover component 27, with bonding material 36 such as an ultraviolet curable resin, over the entire circumference of transparent cover component 9. More specifically, transparent cover component 9 is mounted from above to attachment face 20i provided at a portion of supporting component 20 and attachment face 27a provided on cover component 27. The light path of emission light 11 and wavelength conversion component 4 are sealed.

Cover component 27 is disposed to cover holding component 25. Holding component 25 has a function of holding second optical element 3b, and also has a function of adjusting a position of second optical element 3b. Holding component 25 is fixed to supporting component 20 by screw 52. Cover component 27 is fixed to supporting component 20 by screw 53.

In addition, according to the present embodiment, reflective component 23 is provided to a portion of transparent cover component 9. Accordingly, photodetector 7 receives a portion of radiation light 90 reflected by reflective component 23 provided to transparent cover component 9, through second opening portion 22 defined in supporting component 20.

In light source device 101I configured in this manner, the most dangerous damaged state in which hazardous light is emitted from light source device 101I is the case where holding component 25 and cover component 27 are detached from supporting component 20 as illustrated in FIG. 39. In this case, second optical element 3b located above semiconductor light emitting device 1 is also detached. In this case, emission light 11 emitted from semiconductor light emitting device 1 and collimated by first optical element 3a is emitted from light source device 101I as it is.

According to the present embodiment, as illustrated in FIG. 38 and FIG. 39, when second optical element 3b is detached due to breakage or damage in light source device 101I, cover component 27 is also detached from supporting component 20 prior to the detaching of second optical element 3b. As a result, transparent cover component 9 is detached as well. In this case, photodetector 7 cannot receive radiation light 90 reflected by reflective component 23 disposed on transparent cover component 9. As a result, the amount of radiation light 90 incident on photodetector 7 changes, and thus it is possible to detect that light source device 101I is broken or damaged, making it possible to stop the operation of semiconductor light emitting device 1.

In the present embodiment as well, photodetector 7 disposed at a location off a light path of light which is radiation light 90 and used as illumination light (usable radiation light) receives light reflected by reflective component 23 disposed on transparent cover component 9 as light which is radiation light 90 and not used as illumination light (unnecessary light).

Controller 140 determines an abnormal state of wavelength conversion component 4 based on the amount of unnecessary light received by photodetector 7, and turns on or off semiconductor light emitting device 1 according to the result of the determination by controller 140, thereby making it possible to inhibit radiation light which is high in monochromaticity, directivity, and an energy density as with emission light 11 emitted from semiconductor light emitting device 1 from being emitted to the outside of light source device 101I..

As described above, with light source device 101I according to the present embodiment, as with Embodiment 1 to Embodiment 9, photodetector 7 is disposed at a location off a light path of usable radiation light which is light emitted from wavelength conversion component 4, and used as illumination light 110.

With this configuration, it is possible to accurately detect abnormal deterioration of wavelength conversion component 4 by photodetector 7 to implement light source device 101I with high safety, as well as possible, even when photodetector 7 is used, to inhibit uneveness in light intensity from being generated in an illuminated region of illumination light 110 due to photodetector 7. Furthermore, since it is also possible to implement light source device 101I which is small in size, a projection device which includes light source device 101I can be small in size as well.

In addition, according to the present embodiment, wavelength conversion component 4 is protected by transparent cover component 9. In addition, the light path of emission light 11 and wavelength conversion component 4 are sealed by supporting component 20 to which semiconductor light emitting device 1 is fixed, cover component 27, and transparent cover component 9.

With this configuration, it is possible to implement light source device 101I which excels in dustproof property and waterproof property. More specifically, with the effect of optical tweezers, it is possible to prevent dust, etc., from being collected to the light path of emission light 11 from outside of light source device 101I, attaching to the surface of condenser lens 3, and decreasing the optical properties of light source device 101I. In addition, it is possible to inhibit dust, etc., from entering the light path of emission light 11 from outside light source device 101I and scattering emission light 11. It is possible, by inhibiting this scattering, to inhibit radiation light which is high in monochromaticity, directivity, and an energy density as with emission light from being emitted to the outside of the light source device.

It should be noted that, although transparent cover component 9 on part of which reflective component 23 is disposed has been described as transparent cover component 9 according to the present embodiment, the configuration of the light source device is not limited to this example. A glass plate including antireflection films having reflectance of 0.1% to 2% are formed on the both surfaces may be used as transparent cover component 9, and detection of light may be performed using the reflected light. In addition, even when transparent cover component 9 and reflective component 23 are independently disposed, it is possible to implement the advantageous effect of a sealing property or the like.

### (Other Variations, etc.)

Although the light source device and the projection device according to present disclosure have been described based on the above-described embodiments and the variations, the present disclosure is not limited to the above-described embodiments and the variations.

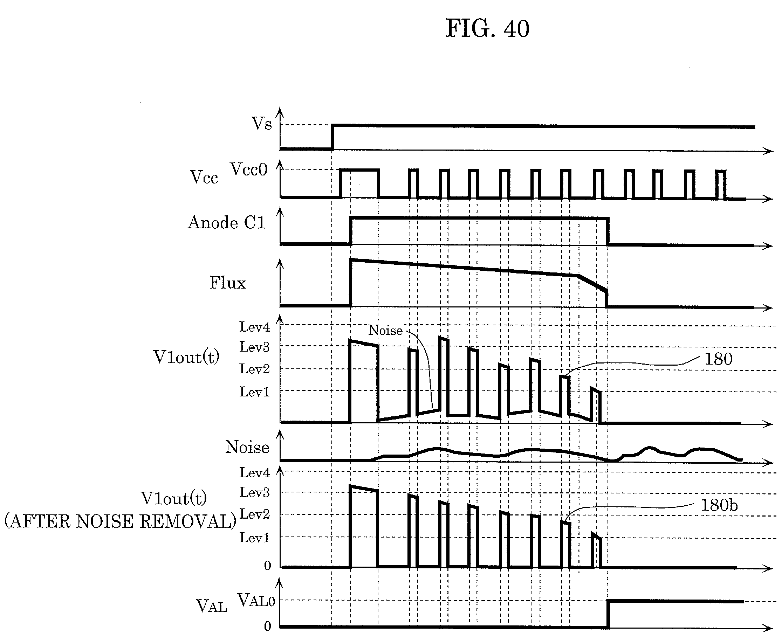

For example, although power supply voltage V_{cc} applied to photodetector 7 is a constant voltage that is continuous wave (CW) driving (continuous oscillation driving) according to the above-described embodiments, power supply voltage V_{cc} applied to photodetector 7 may be a pulse voltage that is pulse driving (instant pulse) as illustrated in FIG. 40. FIG. 40 is an example of a timing chart of each of the signals, luminous flux, and noise in a controller included in a light source device according to a variation example. In this manner, power supply voltage V_{cc} resulting from pulse driving and signal 180 resulting from receiving light by photodetector 7 are synchronized and calculated, thereby making it possible to generate signal 180b in which influence of an external noise signal etc. are removed. With this, it is possible to more accurately detect abnormal deterioration of wavelength conversion component 4. In addition, although a light source device which includes a single semiconductor light emitting device has been described in the above-described embodiments, the present invention is not limited to this example. For example, it is possible to apply the present invention to a light source device which includes a plurality of semiconductor light emitting devices, or a light source device which includes a semiconductor light emitting device on which a semiconductor light emitting element having a plurality of optical waveguides.

In addition, although light emitted from the light source device is used for illumination according to the above-described embodiments, the present disclosure is not limited to this example.

Moreover, embodiments obtained through various modifications to the respective embodiments and variations which may be conceived by a person skilled in the art as well as embodiments realized by arbitrarily combining the structural components and functions of the respective embodiments and variations without materially departing from the spirit of the present disclosure are included in the present disclosure

Although only some exemplary embodiments of the present disclosure have been described in detail above, those skilled in the art will readily appreciate that many modifications are possible in the exemplary embodiments without materially departing from the novel teachings and advantages of the present disclosure. Accordingly, all such modifications are intended to be included within the scope of the present disclosure.

### INDUSTRIAL APPLICABILITY

The present disclosure can be widely used as various optical devices such as a light source device including a semiconductor light emitting element and a wavelength conversion component, a projection device including the light source device, etc.

### REFERENCE MARKS IN THE DRAWINGS

1, 304 semiconductor light emitting device
3 condenser lens
3a first optical element
3b second optical element
4 wavelength conversion component
4a wavelength conversion element
4b reflective component
4c supporting component
4d illuminated region
5 lens holder
7, 307 photodetector
7a, 37a terminal
8 optical filter
9 transparent cover component
10 semiconductor light emitting element
11 emission light
12 package
13a, 13b lead pin
15 can
16 light-transmissive component
20 supporting component
20b, 30f heat dissipation surface
20c separation wall
20d holding portion
20e, 20f, 20i, 27a mounting face
20h, 322 opening portion
21 first opening portion
22 second opening portion
23, 24 reflective component
25, 26 holding component
27 cover component
30 first wiring board
30a board
30b wiring layer
30c wiring layer
30d, 30e through hole
30f via wiring
31 second wiring board
35 solder
36 bonding material
37, 337 external connecting member
38 external line
41 resistive element
42 temperature detection element
43 resistive element
44 protector element
46 difference amplifier
50, 52, 53 screw
90, 90b, 90d, 390 radiation light
91, 91b, 91c, 91d first radiation light
92, 92b, 92c, 92d second radiation light
95 usable radiation range
96 optical axis
101, 101A, 101B, 101B', 101C, 101D, 101E, 101F, 101G, 101G', 101H, 101H', 101I, 300 light source device
110, 310 illumination light
120 projection component
120a, 120b region
121 actuator
130 heat dissipation component
131 mounting portion
132 cooling fin
140 controller
141 microcontroller
142, 143 step-down circuit
150 external circuit
160 power supply
170 warning lamp
180, 180a to 180f signal
190, 191 threshold signal
201, 301, 401 lamp
320 projection component
330 wiring board

## Claims

1. A light source device, comprising:
a semiconductor light emitting device which emits laser light;
a wavelength conversion component which emits fluorescence by being irradiated with the laser light emitted from the semiconductor light emitting device as excitation light; and
a photodetector on which a portion of light emitted from the wavelength conversion component is incident, wherein
the photodetector is disposed at a location off a light path of usable radiation light which is emitted from the wavelength conversion component to a space and used as illumination light.

2. The light source device according to claim 1, further comprising:
a first reflective component which reflects a portion of light which is emitted from the wavelength conversion component and not used as illumination light, in a direction away from a direction of travel of the usable radiation light, wherein
light reflected by the first reflective component is incident on the photodetector.

3. The light source device according to claim 1 or claim 2, further comprising:
a light-transmissive component on the light path of the usable radiation light.

4. The light source device according to claim 2, further comprising:
a light-transmissive component disposed on the light path of the usable radiation light, wherein
the light-transmissive component functions as the first reflective component.

5. The light source device according to claim 3 or claim 4, further comprising:
a supporting component which supports the wavelength conversion component, wherein
the light-transmissive component closes an opening of the supporting component.

6. The light source device according to any one of claims 1 to 4, further comprising:
a supporting component which supports the wavelength conversion component; and
a circuit board attached to the supporting component, wherein
the semiconductor light emitting device and the photodetector are disposed on the circuit board.

7. The light source device according to claim 5 or claim 6, wherein
the supporting component has an opening portion through which light incident on the photodetector passes.

8. The light source device according to claim 7, wherein
the supporting component has a recess which is continuous with the opening portion, and
the photodetector is disposed in the recess.

9. The light source device according to claim 8, further comprising:
a temperature detection element disposed in the recess at position between the semiconductor light emitting device and the photodetector.

10. The light source device according to claim 6, wherein
the circuit board to which the semiconductor light emitting device and the photodetector are attached is a single circuit board, and
the light source device further comprises a controller which is attached to the single circuit board, the controller controlling the semiconductor light emitting device based on an intensity of light incident on the photodetector.

11. The light source device according to claim 10, wherein
the controller cancels a change in light emission of the semiconductor light emitting device due to an environmental temperature, and detects abnormal deterioration of the wavelength conversion component based on a variation in a rate of change of output of the photodetector.

12. The light source device according to claim 10, wherein
unnecessary light included in laser light emitted from the semiconductor light emitting device and reflected by the wavelength conversion component is incident on the photodetector, and
the controller detects an abnormal deterioration of the wavelength conversion component based on a signal from the photodetector.

13. The light source device according to any one of claims 1 to 12, wherein
light which travels in a direction away from a direction of travel of the usable radiation light is incident on the photodetector.

14. The light source device according to claim 13, further comprising:
a second reflective component which reflects laser light emitted from the semiconductor light emitting device, wherein
the wavelength conversion component emits the usable radiation light from a face on which the laser light reflected by the second reflective component is incident.

15. The light source device according to any one of claims 1 to 12, wherein
the wavelength conversion component emits the usable radiation light from a face opposite to a face on which the laser light is incident.

16. The light source device according to any one of claims 1 to 15, further comprising:
an optical element between the semiconductor light emitting device and the wavelength conversion component, the optical element condensing the laser light.

17. A projection device, comprising:
a light source device; and
a projection component which reflects usable radiation light emitted from the light source device, wherein
the light source device includes:
a semiconductor light emitting device which emits laser light;
a wavelength conversion component which emits fluorescence by being irradiated with the laser light emitted from the semiconductor light emitting device as excitation light; and
a photodetector on which a portion of light emitted from the wavelength conversion component is incident, and
the photodetector is disposed at a location off a light path of the usable radiation light included in light emitted from the wavelength conversion component to a space.

18. The projection device according to claim 17, wherein
the light source device includes: a supporting component which supports the wavelength conversion component; and a circuit board attached to the supporting component, and
the circuit board includes an external connecting component on a side opposite to a side to which light reflected by the projection component travels.

19. The projection device according to claim 17, wherein
the light source device includes: a supporting component which supports the wavelength conversion component; and a heat dissipation component attached to the supporting component, and
the heat dissipation component includes a cooling fin on a side opposite to a side to which light reflected by the projection component travels.

20. The projection device according to any one of claims 17 to 19, wherein
the light source device includes a second reflective component which reflects laser light emitted from the semiconductor light emitting device, toward the wavelength conversion component, and
the laser light reflected by the second reflective component travels in a direction opposite to a direction in which light reflected by the projection device travels.
